# EUROPEAN PATENT APPLICATION

(11) **EP 4 640 766 A1**
(43) Date of publication of application: **29.10.2025**
(21) Application number: 23907166.5
(22) Date of filing: 22.12.2023
(51) Int. Cl.: C08L 83/07, B32B 7/06, B32B 27/00, C08K 3/36, C08K 5/14, C08L 83/04, C08L 83/05, C09J 11/04, C09J 11/06, C09J 183/07, H01L 21/52, H01L 21/301

(54) **HOT MELT CURABLE SILICONE COMPOSITION, LAYERED PRODUCT USING SAID COMPOSITION, AND METHOD FOR PRODUCING SEMICONDUCTOR DEVICE**

(30) Priority: 23.12.2022 JP 2022206370
(71) Applicant: Dow Toray Co., Ltd., Tokyo 140-8617 (JP)
(72) Inventor: YAMAZAKI, Ryosuke, Ichihara-shi Chiba 299-0108 (JP); USHIO, Yoshito, Ichihara-shi Chiba 299-0108 (JP)
(74) Representative: Elkington and Fife LLP
(86) International application number: PCT/JP2023/046058
(87) International publication number: WO 2024/135806

(57) **Abstract**

[Problem] Provided is a hot-melt curable silicone composition, a laminate using the composition, and a method for producing a semiconductor device. The curable silicon composition is particularly useful as a material for a die attach film, and allows for easy peel-off of a dicing tape from the surface thereof once the dicing tape becomes unnecessary after the dicing in a process for producing a semiconductor device. The curable silicone composition has an excellent gap filling property and an excellent bonding property between a semiconductor chip and a substrate. [Solution] Provided is a curable silicone composition and use thereof the curable silicone composition comprising: (A) a specific organopolysiloxane resin or a mixture thereof; (B) a linear or branched curable reactive organopolysiloxane that is liquid at 25°C; (C) a predetermined curing agent; and (D) an aerosol silica, the curable silicone composition characterized in that the composition as a whole has a hot-melt property, has a mass ratio of the component (A) to the component (B) in a range of 2.50 to 3.00, and has a content of the component (D) contained in a total amount of the components (A) to (D) in a range of 2.0 to 10 mass%.

## Description

### TECHNICAL FIELD

The present invention relates to a curable silicone composition having hot-melt properties and usable particularly as a material for a die attach film (including sheet). In a process for producing a semiconductor device, the composition allows for easy peel-off, from the surface of the semiconductor device, a dicing tape that becomes unnecessary after the dicing. In addition, the curable silicone composition is excellent in gap filling properties and bondability between a semiconductor chip and a substrate. Furthermore, the present invention relates to a method for producing a semiconductor device using a laminate including the curable silicone composition.

### BACKGROUND ART

Curable silicone compositions are utilized in a wide range of industrial fields because they are cured to form cured products having excellent heat resistance, cold resistance, electrical insulation, weather resistance, water repellency, and transparency. The cured product of such a curable silicone composition generally has a smaller hardness than other organic materials, and is therefore suitable as a member for a semiconductor device that requires a soft material.

Patent Document 1 proposes to use a silicone-based adhesive sheet or film comprising a curable silicone composition like the one described above as a die attach film for a wafer semiconductor chip or semiconductor wafer, but since the adhesive sheet is made of a cured silicone, when the adhesive sheet is pressure-bonded to a semiconductor substrate having a fine pattern or the like, sufficient gap filling may not be performed between the individualized semiconductor chip and the substrate.

The present applicant has proposed, in Patent Document 2 and Patent Document 3, a sheet or film made of a hot-melt curable silicone composition. When a sheet or film comprising such a hot-melt curable silicone composition is used, the irregularities of the semiconductor substrate as described above can be precisely gap-filled, and the semiconductor chip and the substrate can be firmly bonded without a gap, resulting in an advantage of improved reliability, impact resistance, and the like of the resultant semiconductor device.

On the other hand, when a film-like or sheet-like die attach material is used as a die attach film for a wafer semiconductor chip or a semiconductor wafer, the wafer needs to be diced into small pieces (i.e., separated into individual pieces) before being pressure-bonded to a semiconductor. In this dicing step, it is necessary to temporarily fix a laminate composed of a film-like or sheet-like material and a wafer, and for this purpose, a dicing tape is generally used. In particular, a UV-curable dicing tape, represented by Adwill series manufactured by Lintec Corporation, is known. The kind of tape has a property that the adhesive strength is reduced by being irradiated with a high energy beam such as ultraviolet light after dicing. Specifically, in the case of actually producing a semiconductor device, the interaction between the film-shaped or sheet-shaped material and the dicing tape before and after the high energy beam irradiation is an important point. It is desirable that: the dicing tape and the die attach material have sufficient adhesiveness in the dicing step; after the cutting is completed, the dicing tape is removed immediately after the high energy beam irradiation; and the die attach material is thus exposed and can be adhered to the substrate. However, although the hot-melt curable silicone compositions proposed in Patent Documents 2 and 3 have excellent adhesion to the dicing tape before high energy beam irradiation and excellent temporary fixing properties during dicing-cutting, there is a problem that the dicing tape cannot be easily peeled off even when the dicing tape that has become unnecessary after dicing is irradiated with high energy beams. On the other hand, when the adhesion between the die attach material and the dicing tape is weak, the temporary fixing property of the semiconductor wafer may be reduced, resulting in more frequent cutting failure at the time of dicing and a lower yield of individualized pieces. Therefore, a material has been strongly desired which is excellent in gap fill property and can satisfy conflicting requirements that are required of a dicing tape in the process.

### RELATED ART DOCUMENTS

### PATENT DOCUMENTS

Patent Document 1: International Patent Application Publication No. WO2019/124417
Patent Document 2: Japanese Unexamined Patent Application Publication No. 2021-107550
Patent Document 3: Japanese PCT Patent Application 2021-161400

### SUMMARY OF THE INVENTION

### PROBLEM TO BE SOLVED BY THE INVENTION

The present invention has been made to solve the above problems, and provides a hot-melt curable silicone composition having properties suitable for a wafer back-side lamination step for a wafer for semiconductors. Such a curable silicone composition has hot-melt properties, is excellent in gap filling properties and bonding properties between a semiconductor chip and a semiconductor substrate (including a substrate). The curable silicone composition can temporarily fix a dicing tape in a step for dicing a semiconductor wafer, but allows for easy removal of the dicing tape that has become unnecessary after dicing, thereby easily exposing a silicone layer serving as an adhesive or bonding layer, and thus allowing a individualized semiconductor chip to be firmly bonded onto a semiconductor substrate. The present invention also provides a laminate containing the curable silicone composition described above, use thereof, a semiconductor device (particularly, a MEMS device) including a cured product thereof, and a method for producing the curable silicone composition.

### MEANS FOR SOLVING THE PROBLEM

As a result of intensive studies, the present inventors have found that the above problems can be solved by a hot-melt curable silicone composition containing: a particular organopolysiloxane resin and a particular liquid chain organopolysiloxane at a particular mass ratio; and a particular aerosol silica (hereinafter, sometimes referred to as "fumed silica") in a range of 2.0 to 10 mass% with respect to the total amount of the components serving as main agents of the composition. In addition, the present inventors have found that a laminate containing the same, and use thereof (particularly, use as a die attach film for a semiconductor chip or a semiconductor wafer, and use as a semiconductor device precursor) can also be useful for the same purpose and have reached the present invention.

The hot-melt curable silicone composition having the above compositional characteristics exhibits adhesiveness in response to pressure, and thus exhibits a great adhesive strength to an uncured dicing tape having an adhesive strength, but once the dicing tape is cured by high energy beam irradiation or the like and as a result, the adhesive strength thereof is reduced, the hot-melt curable silicone composition becomes easily peelable. Hence, the dicing tape that has become unnecessary after the dicing Step can be easily removed, and the silicone layer serving as an adhesive or bonding layer can be easily exposed. Furthermore, the silicone layer has excellent gap filling properties and can firmly adhere the individualized semiconductor chips onto the semiconductor substrate. Hence, a Step of producing a semiconductor device can be realized by utilizing such advantageous characteristics.

More specifically, the problem can be solved by a curable silicone composition comprising:
(A) an organopolysiloxane resin containing a component (A1) and a component (A2) below at a6 mass ratio of 0:100 to 90:10:
   (A1) an organopolysiloxane resin having no hot-melt properties as a whole molecule, having a curing reactive functional group containing a carbon-carbon double bond in the molecule, and containing a siloxane unit represented by SiO_{4/2} making up at least 20 mol% or more of the total siloxane units, and
   (A2) an organopolysiloxane resin having no hot-melt properties as a whole molecule, having a curing reactive functional group containing at least one carbon-carbon double bond in the molecule, and containing at least 20 mol% or more of the total siloxane units represented by SiO_{4/2};
(B) a straight-chain or branched-chain organopolysiloxane, liquid at 25°C, having a curing reactive functional group containing at least two carbon-carbon double bonds in the molecule;
(C) one or more curing agents selected from (c1) or (c2) below, in an amount necessary to cure the composition:
   (c1) an organic peroxide; and
   (c2) an organohydrogenpolysiloxane having at least two silicon atom-bonded hydrogen atoms per molecule and a hydrosilylation reaction catalyst; and
(D) aerosol silica

and having hot-melt properties for the composition as a whole, the curable silicone composition characterized in that
a mass ratio of the component (A) to the component (B) (=(A)/(B)) is in a range of 2.50 to 3.00, and a content of the component (D) contained in a total amount of the components (A) to (D) is in a range of 2.0 to 10 mass%.
The component (D) may be an aerosol silica having a BET specific surface area of 100 m²/g or more, which is surface-treated with one or more silicon-containing compounds. In addition, the curable silicone composition may comprise (E) a curing retarding agent for a hydrosilylation reaction with a boiling point of 200°C or higher under atmospheric pressure. The composition may be in the form of a sheet or film having a thickness of 10 to 2000 µm, and is preferably a composition particularly for a die attach film.

The curable silicone product of the present invention does not exhibit adhesive property under conditions where no pressure is applied to the surface thereof, but exhibits strong adhesiveness to a substrate in response to pressure such as one exerted at the time of pressure bonding. Hence, the curable silicone product has excellent temporary fixing properties, and sufficiently adheres to an uncured or a B-stage dicing tape having adhesive property. Once the dicing tape is cured by irradiation with high energy beam or the like and the adhesive property thereof is significantly reduced, the adhesive strength is reduced by 30% or more and the dicing tape can be easily peeled off. Furthermore, when a semiconductor chip or a semiconductor wafer that has been separated into individual pieces is bonded onto a substrate, the curable silicone composition of the present invention exposed by removing the dicing tape exhibits gap fill properties and curing adhesiveness to the substrate by heating and melting, and the substrate and the semiconductor chip or the like that has been separated into individual pieces can be strongly bonded together.

Similarly, the above-described problem can be solved by a laminate (including a peelable laminate, a laminate suitable as a member for a semiconductor or a precursor for a semiconductor) and a semiconductor device, each of which comprises the above-described curable silicone composition or a cured product thereof.

Furthermore, the problem can be solved by a method of producing a semiconductor device including the steps of:
(1) laminating, onto a back surface of a semiconductor wafer, a sheet or film comprising the above-described curable silicone composition, with one surface of which sheet or film a dicing tape is in close contact, the dicing tape having a property of reducing an adhesive strength caused by irradiation with a high energy beam;
(2) dicing and thereby individualizing a resultant laminate from the Step (1);
(3) irradiating the dicing tape with a high energy beam and thereby reducing the adhesive strength of the dicing tape;
(4) peeling off the dicing tape from the one surface of the curable silicone composition whose adhesive strength to the dicing tape has been reduced in the Step (3);
(5) disposing an individual piece of the semiconductor wafer on a semiconductor substrate via the resultant curable silicone composition from the Step (4); and
(6): performing a curing reaction by heating a resultant structure from the Step (5) with the individual piece of the semiconductor wafer disposed on the semiconductor substrate and thereby bonding the individual piece of the semiconductor wafer onto the semiconductor substrate.
The Steps 1 to 5 may be modified as follows. A laminate composed of a dicing tape having a property of reducing the adhesive strength by irradiation with a high energy beam and a curable silicone composition layer is first separated into individual pieces. Then, the individualized pieces are disposed on a semiconductor substrate. Then, the dicing tape is peeled off by irradiation with a high energy beam. Then, the individual pieces of the semiconductor wafer are disposed on the substrate. In this way, a process for producing a semiconductor device utilizing the advantageous properties of the curable silicone composition of the present invention can be designed. In the step of bonding the individual pieces of the semiconductor wafer onto the semiconductor substrate with the curable silicone composition (having hot-melt properties), it is particularly preferable to include a step of pressure-bonding with heating in a range of 50 to 200°C so that the advantageous gap fill characteristics can be utilized.

### EFFECT OF THE INVENTION

The curable silicone composition of the present invention has hot-melt properties, and when the curable silicone composition is pressure-bonded with heating to a substrate such as a semiconductor substrate, the curable silicone composition has excellent gap filling properties and bonding properties between a semiconductor chip and a semiconductor substrate (including a substrate). In a step of dicing a semiconductor wafer, the curable silicone composition can temporarily fix a dicing tape with practically sufficient adhesive strength. After dicing, the adhesive strength of the curable silicone composition can be changed by curing the dicing tape having characteristics that the adhesive strength is reduced by irradiation with a high energy beam. Thus, the tape can be easily peeled off. Therefore, by using the curable silicone composition of the present invention in combination with a dicing tape having a characteristic that the adhesive strength is reduced by irradiation with a high energy beam, it is possible to provide a hot-melt curable silicone composition having a characteristic suitable for a wafer back-side lamination step for a semiconductor wafer. This is because the combined use allows for easy removal of the dicing tape once the dicing tape has become unnecessary after the dicing operation. This easily exposes the silicone layer serving as an adhesive or bonding layer and can firmly adhere the individualized semiconductor chip onto the semiconductor substrate. It is also possible to provide a laminate containing such a curable silicone composition, and a use thereof, a semiconductor device (particularly, a MEMS device) comprising a cured product thereof, and a method for producing the same.

The cured product obtained by curing the curable silicone composition is not prone to increased hardness and brittleness even when exposed to a temperature exceeding 150°C for an extended period of time. Thus, in particular, when the cured product is used as a part of a semiconductor device that is to be used at high temperatures, the cured product layer can be prevented from fracturing or cracking over time, and the durability and reliability of the semiconductor device can be improved. In addition, a film or sheet comprising such a curable silicone composition can be efficiently produced by a simple mixing step, and therefore has excellent applicability to industrial production processes.

### DESCRIPTION OF THE PREFERRED EMBODIMENTS

Embodiments of the present invention will be described below in detail. The present invention is not limited by the following embodiments, and various types of modifications may be made within the scope of the gist of the present invention.

In the present invention, unless otherwise stated, "having hot-melt properties" means the softening point of a composition is between 50 and 200°C, and the composition has a melt viscosity at 150°C (preferably, melt viscosity of less than 1000 Pa·s) and has flowable properties. Therefore, in the present specification, the curable silicone composition having hot-melt properties of the present invention is also referred to as a curable hot-melt silicone composition.

In the present invention, atmospheric pressure refers to the atmospheric pressure in the environment where the curable silicone composition is handled in a laboratory, factory, or the like, and although not limited to a specific pressure, usually refers to an atmospheric pressure ranging from 1 atm (1013.25 hPa) to minus 100 hPa to plus 100 hPa, and particularly 1 atm (1013.25 hPa).

In the present specification, room temperature means the temperature of an environment where the curable silicone composition of the present invention is handled. Room temperature typically refers to 0°C to 40°C, particularly refers to 15 to 30°C, and more particularly refers to 18°C to 25°C.

### [Curable Hot-Melt Silicone Composition]

The curable hot-melt silicone composition of the present invention may contain:
(A) an organopolysiloxane resin containing a component (A1) and a component (A2) below at a6 mass ratio of 0:100 to 90:10:
   (A1) an organopolysiloxane resin having no hot-melt properties as a whole molecule, having a curing reactive functional group containing a carbon-carbon double bond in the molecule, and containing a siloxane unit represented by SiO_{4/2} making up at least 20 mol% or more of the total siloxane units, and
   (A2) an organopolysiloxane resin having no hot-melt properties as a whole molecule, having a curing reactive functional group containing at least one carbon-carbon double bond in the molecule, and containing at least 20 mol% or more of the total siloxane units represented by SiO_{4/2};
(B) a straight-chain or branched-chain organopolysiloxane, liquid at 25°C, having a curing reactive functional group containing at least two carbon-carbon double bonds in the molecule;
(C) one or more curing agents selected from (c1) or (c2) below, in an amount necessary to cure the composition:
   (c1) an organic peroxide; and
   (c2) an organohydrogenpolysiloxane having at least two silicon atom-bonded hydrogen atoms per molecule and a hydrosilylation reaction catalyst; and
(D) aerosol silica

and having hot-melt properties for the composition as a whole, the curable silicone composition characterized in that
a mass ratio of the component (A) to the component (B) (=(A)/(B)) is in a range of 2.50 to 3.00, and a content of the component (D) contained in a total amount of the components (A) to (D) is in a range of 2.0 to 10 mass%.

Practically, it is particularly preferable that the component (A) should be an organopolysiloxane resin having a mass reduction ratio of 2.0 mass% or less when exposed to 200°C for one hour. The reason for this will be described later.

In addition, in the curable hot-melt silicone composition of the present invention, a hydrosilylation reaction retarding agent, a so-called cure retarding agent, may be used by optional selection, but in that case, (E) a cure retarding agent with a boiling point of 200°C or higher, in particular, a boiling point of 200°C or higher under one atmosphere of pressure (1,013.25 hPa) is preferably used. Furthermore, the curable hot-melt silicone composition of the present invention may have other additives known in the art, added within a scope where the properties intended by the present invention can be maintained.

### [Hot-Melt Properties and Composition of Curable Silicone Compositions]

The curable silicone composition according to the present invention has hot-melt properties as a whole and can flow under heated conditions. In particular, the curable silicone composition of the present invention preferably has a softening point of 50°C or higher and melt viscosity at 150°C (preferably, a melt viscosity that is less than 5000 Pa.s when measured using a Koka flow meter as described below). Note that in the present invention, only the composition as a whole needs to have hot-melt properties, and individual components forming the composition (Component (A) in particular) is an organopolysiloxane resin that does not have hot-melt properties.

### [Component (A)]

The curable silicone composition according to the present invention is an organopolysiloxane resin mixture comprising, as component (A): (A1) an organopolysiloxane resin that is solid at 25°C, having a curing reactive functional group that contains a carbon-carbon double bond, containing Q units accounting for 20 mol% or more of all siloxane units, and not exhibiting hot-melt properties alone; and (A2) an organopolysiloxane resin that is a solid at 25°C, not having a curing reactive functional group that contains a carbon-carbon double bond, containing Q units accounting for 20 mol% or more of all siloxane units, and not exhibiting hot-melt properties alone, wherein the component (A1) and the component (A2) are contained at a mass ratio of 0:100 to 90:10, 20:80 to 90:10, 35:65 to 90:10, or 50:50 to 90:10. The organopolysiloxane resin may further contain a siloxane unit expressed by R₃SiO_{1/2}, R₂SiO_{2/2}, or RSiO_{3/2} (R represents a monovalent organic group, and particularly a monovalent hydrocarbon group with 1 to 10 carbon atoms), or a hydroxyl group, or an alkoxy group expressed by R²O_{1/2} (R² represents a hydrogen atom or an alkyl group having 1 to 10 carbon atoms), but preferably includes Q units accounting for 20 mol% or more, preferably 40 mol% or more, and particularly preferably within a range of 40 to 90 mol% of all siloxane units. If the amount of Q units is less than 20 mol%, a technical effect of the present invention may not be achieved even if the organopolysiloxane resin contains a large amount of another branched siloxane unit (for example, RSiO_{3/2}), for example.

Here, curing reactive refers to being capable of reacting with organohydrogensiloxane of component (C) by hydrosilylation reaction, thereby enabling the entire composition to be cured, and also refers to a curing reactive functional group containing a carbon-carbon double bond in the molecule, such as an alkenyl group, an acryloxy group, and the like.

Although component (A) described above does not have hot-melt properties alone, the composition of the present invention can have hot-melt properties by concomitant use of component (B) described later in a prescribed quantitative ratio range. Further, it is necessary to contain the component (A) and the component (B) at a predetermined mass ratio from the viewpoint of a change in adhesive strength to a dicing tape, which is one of the technical effects of the present invention.

By using component (A1) in combination with component (A2) at a mass ratio mentioned above in the present composition, it is possible to adjust to a certain degree the storage elastic modulus, loss elastic modulus, and tan δ calculated from the ratio therefrom of a cured product obtained by curing the curable composition, thereby achieving an elastic modulus, flexibility, and stress relaxation properties that are suitable for the cured product. Furthermore, a curable hot-melt silicone composition with desired properties in the present invention can be prepared by combining component (A2) with component (B) without component (A1).

[(A1) Organopolysiloxane Resin Having a Curing Reactive Functional Group]
Component (A1) described above is one base compound of the present composition, and is an organopolysiloxane resin that contains Q units accounting for at least 20 mol% or more of all siloxane units, has no hot-melt properties alone, and has a curing reactive functional group containing a carbon-carbon double bond in a molecule.

Component (A1) must have a curing reactive group having a carbon-carbon double bond in a molecule. Such a curing reactive group is a hydrosilylation reactive functional group, which can form a cured material by a hydrosilylation cross-linking reaction with component (C). These curing reactive groups may be alkenyl groups, especially alkenyl groups with 2 to 10 carbons, such as vinyl groups and hexenyl groups.

Component (A1) is an organopolysiloxane resin that independently does not have hot-melt properties and is solid in a solvent-free state. Herein, the absence of hot-melt properties means that the organopolysiloxane resin, which is component (A1), does not exhibit heating and melting behavior independently at 200°C or lower, and specifically means that the component does not have a softening point or melt viscosity at a temperature of 200°C or lower. In order to exhibit such properties, the component (A1) has a functional group in the organopolysiloxane resin that is a functional group selected from monovalent hydrocarbon groups with 1 to 10 carbon atoms, and particularly methyl groups and other alkyl groups with 1 to 10 carbon atoms, and does not substantially contain a phenyl group or other aryl group. For example, the ratio of aryl groups in all organic groups bonded to silicon atoms is 5 mol% or less, or 2 mol% or less, but preferably no aryl groups are included at all. If component (A1) contains a large amount of aryl groups such as a phenyl group as an organic group, the component may independently be hot-meltable, and the effect of reinforcing a cured product derived from Q units may be reduced.

Preferably, the functional group bonded to a silicon atom in the organopolysiloxane resin of component (A1) is a group selected from methyl groups or alkenyl groups such as a vinyl group. 70 to 99 mol% of all organic groups bonded to silicon atoms may be methyl groups. Other organic groups bonded to a silicon atom may be an alkenyl group such as a vinyl group. In such a range, component (A1) is not hot-meltable alone, but is useful as a component that is particularly excellent in coloring resistance and the like at the high temperatures of a cured product obtained from the curable silicone composition of the present invention. Note that the organopolysiloxane resin of component (A1) may contain a small amount of a hydroxyl group or alkoxy group.

Component (A1) is an organopolysiloxane resin that is solid in the absence of a solvent, and preferably, component (A1) is an organopolysiloxane resin that is solid at 25°C and does not independently have hot-melt properties, expressed by
(A1-1) the following average unit formula:

   (R¹₃SiO_{1/2})ₐ(R¹₂SiO_{2/2})_{b}(R¹SiO_{3/2})_{c}(SiO_{4/2})_{d}(R²O_{1/2})ₑ
(wherein each R¹ independently represents a monovalent hydrocarbon group with 1 to 10 carbon atoms, but 1 to 12 mol% of all R¹s in a molecule represents an alkenyl group; each R² represents a hydrogen atom or an alkyl group with 1 to 10 carbon atoms; and a, b, c, d, and e represent numbers that satisfy 0.10 ≤ a ≤ 0.60, 0 ≤ b ≤ 0.70, 0 ≤ c ≤ 0.80, 0.20 ≤ d ≤ 0.65, and 0 ≤ e ≤ 0.05, but 0.20 ≤ c + d and a + b + c + d = 1).

In the aforementioned average unit formula, each R¹ independently represents a monovalent hydrocarbon group having 1 to 10 carbon atoms. Examples include methyl groups and other alkyl groups; vinyl groups and other alkenyl groups; and phenyl groups and other aryl groups. Furthermore, 1 to 12 mol% of all R¹s in one molecule are alkenyl groups, and 2 to 10 mol% of all R¹s in one molecule are alkenyl groups, and particularly preferably a vinyl group. If the alkenyl group content is less than the lower limit of the range described above, the mechanical strength (hardness and the like) of the resulting cured material may be insufficient. On the other hand, if the amount of the alkenyl group is at or below the upper limit of the range described above, the composition containing the component can achieve favorable hot-melt performance as an entire composition.

In the formula above, R² is an alkyl group having a hydrogen atom or 1 to 10 carbon atoms. Examples of alkyl groups in R² include methyl groups. The group R²O_{1/2} containing the R² corresponds to a hydroxyl group or alkoxy group of the organopolysiloxane resin of component (A).

In the formula, "a" is a number indicating the percentage of siloxane units in the general formula: R¹₃SiO_{1/2}. "a" satisfies 0.1 ≤ a ≤ 0.60, and satisfies 0.15 ≤ a ≤ 0.55. If "a" is at or above the lower limit of the aforementioned range, the composition containing the component can achieve favorable hot-melt performance as a whole composition. On the other hand, if "a" is less than or equal to the upper limit of the aforementioned range, the mechanical strength (hardness, elongation rate, and the like) of the cured product obtained by curing the curable silicone composition of the present invention is not too low.

In the formula, "b" is a number indicating the percentage of siloxane units in the general formula: R¹₂SiO_{2/2}. "b" is a value that satisfies 0 ≤ b ≤ 0.70, and satisfies 0 ≤ b ≤ 0.60. If "b" is less than or equal to the upper limit of the aforementioned range, the composition containing the component can achieve favorable hot-melt performance as a whole composition and a composition with little stickiness at room temperature can be obtained.

In the formula, "c" is a number indicating the percentage of siloxane units in the general formula: R³SiO_{3/2}. "c" is a value that satisfies 0 ≤ c ≤ 0.80, and satisfies 0 ≤ c ≤ 0.75. If "c" is less than or equal to the upper limit of the aforementioned range, the composition containing the component can achieve favorable hot-melt performance as a whole composition and a low-tack or tack-free composition with little stickiness at room temperature can be obtained. In the present invention, c may be and is preferred to be 0.

In the above formula, d is a number indicating the ratio of Q units, and may be such that 0.20 ≤ d ≤ 0.65, or 0.25 ≤ d ≤ 0.65. If "d" is within the aforementioned numerical value range, the composition containing this component can achieve favorable hot-melt performance as a whole composition, and a cured product obtained by curing the composition can be relatively hard and have sufficient flexibility for practical use.

In the formula above, "e" is a number indicating the percentage of units in the general formula: R²O_{1/2}, where the units are a hydroxyl group or alkoxy group bonded to a silicon atom that can be included in the organopolysiloxane resin. "e" satisfies the equation 0 ≤ e ≤ 0.05, and preferably satisfies 0 ≤ e ≤ 0.03. If "e" is below the upper limit of the range, a material that achieves favorable hot-melt performance as an entire composition can be obtained. Note that in the formula above, the sum of "a", "b", "c" and "d", which is the sum of each siloxane unit, is equal to 1.

Component (A1) is an organopolysiloxane resin having the aforementioned properties, and is a solid at room temperature, so in order to physically blend with component (B) described below, component (A1) may be used in a state dissolved in a solvent or solvent mixture selected from a group comprising: toluene, xylene, mesitylene, and other aromatic hydrocarbons; tetrahydrofuran, dipropyl ether, and other ethers; hexamethyldisiloxane, octamethyltrisiloxane, decamethyltetrasiloxane, and other silicones; ethyl acetate, butyl acetate, propylene glycol monomethyl ether acetate, and other esters; acetone, methyl ethyl ketone, methyl isobutyl ketone, and other ketones; and the like. The solvent used herein can be efficiently removed in a process described later.

### [Organopolysiloxane Resin (A2) without Curing Reactive Functional Group]

Component (A2) is one base compound of the present composition, is an organopolysiloxane resin that is solid at 25°C, not having hot-melt properties alone and not containing a curing reactive functional group, and is a component for achieving hot-melt properties of the curable silicone composition as a whole and excellent stress relaxation properties of a cured material obtained by curing the curable silicone composition through use in combination with component (A1) and component (B) described above within a prescribed quantitative range.

Component (A2) is an organopolysiloxane resin that independently does not have hot-melt properties and is solid in a solvent-free state. The behavior of component (A2) not having hot-melt properties and the absence of an aryl group, such as a phenyl group, is similar to that of component (A1).

Component (A2) is an organopolysiloxane resin which, similar to component (A1), is a solid at 25°C and contains Q units accounting for 20 mol% or more of all siloxane units, but does not have a curing reactive functional group containing at least one carbon-carbon double bond in a molecule. In other words, component (A2) does not contain an alkenyl group such as a vinyl group or the like as a functional group in the organopolysiloxane resin. Examples of groups provided by the organopolysiloxane resin of component (A2) include monovalent hydrocarbon groups with 1 to 10 carbon atoms, and particularly methyl groups and other alkyl groups with 1 to 10 carbon atoms. The organopolysiloxane resin must be substantially free of phenyl groups or other aryl groups. For example, the ratio of aryl groups of all organic groups bonded to a silicon atom is 5 mol% or less, or 2 mol% or less, and preferably no aryl groups are included at all.

Preferably, the functional group bonded to the silicon atom in component (A2) is an alkyl group having 1 to 10 carbon atoms, such as a methyl group, and 70 to 100 mol% of all organic groups bonded to a silicon atom may be methyl groups. Within this range, component (A2) can be a component that does not individually exhibit hot-melt properties, and that is particularly effective in reinforcing a cured material containing siloxane units expressed by SiO_{4/2}. Note that the organopolysiloxane resin of component (A2) may contain a small amount of a hydroxyl group or alkoxy group.

Component (A2) does not have a curing reactive functional group having a carbon-carbon double bond in a molecule, and thus independently does not form a cured product when combined with organohydrogenpolysiloxane, which is component (C), but improves the hot-melt properties of the curable silicone composition of the present invention and has a reinforcing effect with regard to cured product obtained by curing the curable silicone composition. Furthermore, the hot-melt properties of the resulting curable silicone composition and the physical properties of the composition after curing can be adjusted, if necessary, by using component (A1) having a curing reactive functional group.

Component (A2) is an organopolysiloxane resin that is solid at 25°C in a solvent-free state, and 20 mol% or more of all siloxane units in each molecule are Q units which are branched siloxane units. Preferably, the ratio of Q units to all of the organopolysiloxane of component (A2) is 40 mol% or more, or 50% or more, and particularly within a range of 50 to 65 mol%.

Preferably, component (A2) is (A2-1) an organopolysiloxane resin which does not independently have hot-melt properties, having the average unit formula:

(R³₃SiO_{1/2})_{f}(R³₂SiO_{2/2})_{g}(R³SiO_{3/2})ₕ(SiO_{4/2})ᵢ(R²O_{1/2})ⱼ

(wherein each R³ independently represents a monovalent hydrocarbon group with 1 to 10 carbon atoms and that does not contain a carbon-carbon double bond; R² represents a hydrogen atom with an alkyl group with 1 to 10 carbon atoms; and f, g, h, i, and j represent numbers that satisfy 0.35 ≤ f ≤ 0.55, 0 ≤ g ≤ 0.20, 0 ≤ h ≤ 0.20, 0.45 ≤ i ≤ 0.65, 0 ≤ j ≤ 0.05, and f + g + h + i = 1).

In the average unit formula above, each R³ independently represents a monovalent hydrocarbon group having 1 to 10 carbon atoms and containing no carbon-carbon double bond. Examples includes groups selected from a group consisting of methyl groups and other alkyl groups; phenyl groups and other aryl groups; and benzyl groups and other aralkyl groups. Herein, it is particularly preferred from the perspective of industrial production and the technical effect of the invention that 70 mol% or more of the total R³ in one molecule is a methyl group or other alkyl group with 1 to 10 carbon atoms, and particularly a methyl group. On the other hand, R³ is preferably substantially free of phenyl groups and other aryl groups. If a large amount of phenyl groups or other aryl groups are included, component (A2) itself may have hot-melt properties, the technical effect of the present invention may not be achieved, and the coloring resistance under high temperatures of a cured product obtained by curing the curable silicone composition of the present invention may deteriorate.

In the formula above, R² is as described above, but when R² represents an alkyl group, an example of the alkyl group is a methyl group.

In the formula, "f" is a number indicating the percentage of siloxane units of the general formula: R³₃SiO_{1/2}. f is a value that satisfies 0.35 ≤ f ≤ 0.55, or 0.40 ≤ f ≤ 0.50. If "f" is at or above the lower limit of the aforementioned range, the curable silicone composition containing the component can achieve favorable hot-melt performance as a whole composition. On the other hand, if "f" is less than or equal to the upper limit of the aforementioned range, the mechanical strength (hardness, and the like) of the cured material obtained is not too low.

In the formula, "g" is a number indicating the percentage of siloxane units in the general formula: R¹₂SiO_{2/2}. g is a value that satisfies 0 ≤ g ≤ 0.20, or 0 ≤ g ≤ 0.10. If "g" is less than or equal to the upper limit of the range, the curable silicone composition containing the component can achieve favorable hot-melt performance as a whole composition and a composition with little stickiness at room temperature can be obtained. In the present invention, g may be 0.

In the formula, "h" is a number indicating the percentage of siloxane units in the general formula: R¹SiO_{3/2}. h is a value that satisfies 0 ≤ h ≤ 0.20, or 0 ≤ h ≤ 0.10. If "h" is less than or equal to the upper limit of the range, the curable silicone composition containing the component can achieve favorable hot-melt performance as a whole composition and a composition with little stickiness at room temperature can be obtained. In the present invention, h may be 0.

In the above formula, i is a number indicating the ratio of Q units, and should satisfy 0.45 ≤ i ≤ 0.65, or 0.50 ≤ i ≤ 0.65. When "i" is within the numerical value range, the curable silicone composition containing this component can achieve favorable hot-melt performance as a whole composition, and thus a composition can be achieved, which has excellent mechanical strength of a cured product obtained by curing the curable silicone composition, has no stickiness as a whole composition, and has favorable handleability.

In the formula above, "j" is a number indicating the percentage of units of the general formula: R²O_{1/2}, where the units are a hydroxyl group or alkoxy group bonded to a silicon atom that can be included in the organopolysiloxane resin. "j" is a value that satisfies 0 ≤ j ≤ 0.05, or 0 ≤ j ≤ 0.03. If "j" is at or below the upper limit of the aforementioned range, the curable silicone composition as a whole can achieve a favorable hot-melt performance. Note that in the formula above, the sum of "f", "g", "h" and "i", which is the sum of each siloxane unit, is equal to 1.

Component (A2) is an organopolysiloxane resin having the aforementioned characteristics, and is similar to the aforementioned component (A1) in terms of handling properties. In other words, component (A2) is solid at room temperature (for example, 25°C), and thus, like component (A1), can be used dissolved in the solvent or solvent mixture described above in order to mix with component (B). Thereafter, the solvent can be removed to prepare a curable silicone composition.

### [Mass Reduction Rate of Component (A) and Preparation Method]

**The** components (A1) and (A2) particularly preferably have a mass reduction ratio of 2.0 mass% or less when exposed to 200°C for 1 hour. These components are organopolysiloxane resins containing M units (R³₃SiO_{1/2}) and Q units (SiO_{4/2}), and volatile low molecular weight components, specifically M₄Q structures, are generated as by-products during the polymerization process. However, this structure has significantly reduced strength of a cured product obtained from the curable silicone composition of the present invention, and if a curable silicone composition containing the M₄Q structure is molded together with a substrate of a semiconductor or the like, and then exposed to a high temperature to remove the M₄Q structure, the volume of a cured product resulting from the curable silicone composition may decrease and the hardness of the cured product may significantly increase, resulting in changes in the dimensions of a molded product, warping, and the like. Furthermore, there is a possibility that the tackiness of the surface of the cured product may increase. Furthermore, if a large amount of M₄Q structure remains in the composition or cured product, a marked increase in hardness may also occur in the adhesive layer or sealing layer for double-sided adhesion, and the elastic modulus may change significantly. Therefore, in order to apply the curable silicone compositions of the present invention to applications laminated with a substrate of a semiconductor or the like, the M₄Q structure is preferably removed from the organopolysiloxane resin at the point of a raw material prior to a molding process of curing with the curable silicone composition by laminating with a substrate, and, if possible, prior to preparing the curable silicone composition.

However, the M₄Q structure is highly compatible with organopolysiloxane resins, and it is difficult to remove volatile low molecular weight components, specifically the M₄Q structure, from the component (A1) and/or the component (A2) and the like under drying conditions that remove organic solvents. Therefore, since volatile components can be removed by treating the resulting crude raw material, organopolysiloxane resin, for a short time at a high temperature of approximately 200°C, volatile components such as organic solvents and M₄Q structures and the like can be simultaneously removed from components (A1) and/or (A2) using a twin-screw kneader or the like set at a temperature of 200°C or higher, and thereby, volatile low molecular weight components in components (A1) and (A2) are removed from the raw material before the curable silicone composition is prepared, and thus components (A1) and (A2) preferably have a mass reduction ratio of 2.0 mass% or less after 1 hour of exposure at 200°C, but the mass reduction ratio is more preferably 1. 0 mass% or less.

Note that from the perspective of efficient production of the curable hot-melt silicone composition of the present invention, component (B), described later, is preferably added to the components (A1) and (A2) that are dissolved in an organic solvent, and the mixture is fed in a liquid state into a twin-screw extruder set at 200°C or higher, and a process of removing volatile components such as M₄Q structures and the like is performed. This method enables obtaining a mixture of the components (A1) and (A2) and the component (B), having hot-melt properties as a whole mixture, which can be used for kneading in the remaining components included in the curable silicone composition in a process described later.

### [(B) Liquid and Curing Reactive Chain Organopolysiloxane]

Component (B) is one main component of the present curable silicone composition, is a straight-chain or branched-chain organopolysiloxane, is liquid or has plasticity at 25°C, and has at least two curing reactive functional groups containing carbon-carbon double bonds in each molecule. Such a curing reactive chain organopolysiloxane, when mixed with the solid organopolysiloxane resin of component (A) described above, can exhibit hot-melt properties as an entire composition.

Component (B) must have a curing reactive functional group having a carbon-carbon double bond in a molecule. Such a curing reactive functional group is hydrosilylation reactive, and forms a cured material by a crosslinking reaction with another component. This curing reactive functional group can be an alkenyl group similar to that of component (A1), and in particularly, can be a vinyl group or hexenyl group.

Component (B) is a straight-chain or branched-chain organopolysiloxane that is liquid or has plasticity at 25°C (room temperature), and when mixed with component (A) in a solid state at room temperature, the composition as a whole can exhibit hot-melt properties. A chemical structure of the organopolysiloxane of component (B) may be a straight-chain organopolysiloxane, or a branched-chain organopolysiloxane having a small number of branched siloxane units (for example, a T unit expressed by general formula: R⁴SiO_{3/2} (where R⁴ independently represents a monovalent hydrocarbon group with 1 to 10 carbon atoms) or a Q unit expressed by SiO_{4/2}), but is preferably a straight-chain diorganopolysiloxane represented by
the following structural formula (B1):

   R⁴₃SiO(SiR⁴₂O)ₖSiR⁴₃
(wherein each R⁴ independently represents a monovalent hydrocarbon group with 1 to 10 carbon atoms, but at least two of the R⁴s in one molecule represents an alkenyl group, and k represents a number from 400 to 10,000). A straight-chain diorganopolysiloxane having an alkenyl group, and particularly preferably a vinyl group at both ends of a molecular chain is preferred.

In the formula, each R⁴ independently represents a monovalent hydrocarbon group having 1 to 10 carbon atoms. Examples include groups selected from a group consisting of methyl groups and other alkyl groups; vinyl groups and other alkenyl groups; phenyl groups and other aryl groups; and benzyl groups and other aralkyl groups. Furthermore, at least two of the R⁴ in each molecule are alkenyl groups, such as a vinyl group. Furthermore, each R⁴ can be a functional group selected from a group consisting of methyl groups and other alkyl groups with 1 to 10 carbon atoms and vinyl groups, hexenyl groups and other alkenyl groups, and of all R⁴s, at least two in each molecule can be alkenyl groups, and the remaining R⁴ can be methyl groups. Note that from the viewpoint of a technical effect of the invention, R⁴ is preferably substantially free of an aryl group such as a phenyl group or the like. If a large amount of phenyl groups or other aryl groups are included, the coloring resistance at high temperatures of the cured material obtained from the curable silicone composition may deteriorate. Particularly preferably, a vinyl group or other alkenyl group is provided at each end of the molecular chain, with the remainder of R⁴ being methyl groups.

In the above formula, k is a number between 400 and 10,000, or between 400 and 5,000. If k is at or above the lower limit of the aforementioned range, a curable silicone composition having a certain degree of softness at room temperature can be obtained. On the other hand, if k is at or below the upper limit of the aforementioned range, the curable silicone composition as a whole can achieve a favorable hot-melt performance.

### [Mass Ratio of Component (A) and Component (B)]

In order that the composition as a whole exhibits hot-melt properties and can be smoothly peeled from a dicing tape described later after temporary fixing in the present invention, the mass ratio of the component (A) to the component (B) (i.e., (A)/(B)) needs to be within a range of 2.50 to 3.00. When the mass ratio of the component (A) to the component (B) is within the above-mentioned range, the resultant curable silicone composition exhibits good hot-melt properties on the premise of using the component (D), which is to be described later, in combination. In addition, the curable silicone composition does not exhibit adhesive property under conditions where no pressure is applied to the surface thereof, but exhibits strong adhesiveness to a substrate in response to a pressure such as one exerted at the time of pressure bonding. Hence, temporary fixing with a dicing tape having an adhesive strength can be easily performed. Furthermore, the composition adheres well to a dicing tape that is in an uncured or B-stage state and has adhesive properties. Once the dicing tape is cured by irradiation with a high energy beam or the like and the adhesive strength thereof is greatly reduced, the peeling off (removal) thereof can be easily performed. In addition, the mechanical strength of the cured product obtained by curing the curable silicone composition can be increased. On the other hand, when the mass ratio represented by (A)/(B) is less than the lower limit, the liquid component is excessive, and the hot-melt property may not be realized. Furthermore, when the mass ratio represented by (A)/(B) exceeds the upper limit, the adhesion between the curable silicone composition and the dicing tape is reduced, and the two may peel off before the temporary fixing or during the dicing step.

### [(C) Curing Agent]

Component (C) is a curing agent for curing component (A) and component (B) described above, and is specifically one or more curing agents selected from (c1) or (c2) below. Two or more of these curing agents may be used in combination, for example, the cure system may include both a (c1) component and a (c2) component.
(c1) an organohydrogenpolysiloxane having at least two silicon atom-bonded hydrogen atoms per molecule and a hydrosilylation reaction catalyst; and
(c2) an organic peroxide.

The organohydrogenpolysiloxane having at least two silicon-bonded hydrogen atoms in the (c1) molecule and the hydrosilylation reaction catalyst are components that cure the composition by an addition reaction (hydrosilylation reaction) of the organohydrogenpolysiloxane, which is a crosslinking agent, with the carbon-carbon double bond in the component (A) and the component (B) in the presence of the hydrosilylation reaction catalyst.

The structure of the organohydrogenpolysiloxane (c1-1), which is a part of the component (c1), is not particularly limited and may be linear, branched, cyclic, or resinous. In other words, it may be an organohydrogenpolysiloxane having, as the main constituent unit, a hydrogen organosiloxy unit represented by HR₂SiO_{1/2} (D^{H} unit, wherein R is independently a monovalent organic group), and at the end thereof a hydrogen diorganosiloxy unit represented by HR₂SiO_{1/2} (M^{H} unit, wherein R is independently a monovalent organic group).

On the other hand, when the curable silicone composition film is used by being integrated with the dicing tape, some types of dicing tape may inhibit the hydrosilylation reaction. Hence, the composition of the present invention should have high resistance to cure inhibition. From this point of view, the organohydrogenpolysiloxane contains a monoorganosiloxy unit represented by RSiO_{3/2} (T unit, wherein R is a monovalent organic group or a silicon-bonded hydrogen atom) or a siloxy unit (Q unit) represented by SiO_{4/2}, and at least two hydrogen diorganosiloxy units represented by HR₂SiO_{1/2} (M^{H} unit, where R is independently a monovalent organic group), and the organohydrogenpolysiloxane resin having the M^{H} unit at the molecular terminal is preferred.

Particularly suitable organohydrogenpolysiloxanes are expressed by the following average compositional formula (1):

(R⁴₃SiO_{1/2})ₐ(R⁵₂SiO_{2/2})_{b}(R⁵SiO_{3/2})_{c}(SiO_{4/2})_{d}(R²O_{1/2})ₑ (1)

(where R⁴ independently represents an unsubstituted or substituted monovalent hydrocarbon group that does not contain a hydrogen atom or an aliphatic unsaturated bond with 1 to 12 carbon atoms, R⁶ independently represents an unsubstituted or substituted monovalent hydrocarbon group containing an aliphatic unsaturated bond with 1 to 12 carbon atoms, at least two of all R⁴s represent hydrogen atoms, and a, b, c, and d represents numbers that satisfy conditions of 0.01 ≤ a ≤ 0.6, 0 ≤ b, 0 ≤ c ≤ 0.9, 0 ≤ d ≤ 0.9, and a + b + c + d = 1 and c + d ≥ 0.2). Note that the organohydrogenpolysiloxane may optionally have and preferably has a mass reduction ratio relative to pre-exposure of 10% or less after exposure to 100°C for 1 hour under atmospheric pressure.

In the formula above, each R⁴ represent the same or different hydrogen atom or monovalent hydrocarbon group with 1 to 12 carbon atoms without an aliphatic unsaturated carbon bond. However, at least two, and preferably at least three R⁴s in one molecule are hydrogen atoms. The monovalent hydrocarbon group corresponding to R⁴ excluding hydrogen atoms includes, for example: methyl groups and other alkyl groups; phenyl groups and other aryl groups; benzyl groups and other aralkyl groups; other halogenated alkyl groups; and the like. From an industrial standpoint, the monovalent hydrocarbon group expressed by R⁴ can independently be a methyl group or a phenyl group.

In the formula, R⁵ represents a monovalent hydrocarbon group with 1 to 12 carbon atoms without an aliphatic unsaturated carbon bond, and examples include the same groups as the monovalent hydrocarbon group of R⁴ described above. R⁵ can be a group selected from methyl groups and phenyl groups.

In the formula, "a", "b", "c", and "d" are numbers satisfying the following conditions: 0.01 ≤ a ≤ 0.6; 0 ≤ b; 0 ≤ c ≤ 0.9; 0 ≤ d ≤ 0.9; a + b + c + d = 1; and c + d ≥ 0.2. Specific examples include M^{H}MT resins, M^{H}T resins, M^{H}MTQ resins, M^{H}MQ resins, M^{H}DQ resin, M^{H}Q resins, and the like. In the notation of the resin above, M, D, T, and Q represent a M unit, D unit, T unit, and Q unit, respectively, and M^{H} represents an M unit with a hydrogen atom.

In the formula (1) above, R² is an alkyl group having a hydrogen atom or 1 to 10 carbon atoms. Examples of alkyl groups in R² include methyl groups and the like. The group R²O_{1/2} containing the R² corresponds to a hydroxyl group or alkoxy group of the organohydrogenpolysiloxane of component (c1-1).

In the formula above, "e" is a number indicating the percentage of units in the general formula: R²O_{1/2}, where the units are a hydroxyl group or alkoxy group bonded to a silicon atom that can be contained in the organopolysiloxane resin. e is a value that satisfies 0 ≤ e ≤ 0.05 and 0 ≤ e ≤ 0.03. Note that in the formula (1) above as described above, the sum of "a", "b", "c" and "d", which is the sum of each siloxane unit, is equal to 1.

Examples of the component (c1-1) include organohydrogenpolysiloxanes expressed by the following average compositional formula (2):

(HR⁶₂SiO_{1/2})_{f}(R⁶₂SiO_{2/2})_{g}(SiO_{4/2})ₕ (2)

In formula (2), R⁶ independently represents an unsubstituted or substituted monovalent hydrocarbon group that does not contain an aliphatic unsaturated bond with 1 to 12 carbon atoms, and f, g, and h are values that satisfy the conditions of 0.01 ≤ f ≤ 0.6, 0 ≤ g ≤ 0.9, 0.2 ≤ h ≤ 0.9, and f + g + h = 1.
Specific examples of the monovalent hydrocarbon group include the same as those indicated as specific examples of the monovalent hydrocarbon group expressed by R⁴ in average compositional formula (1) above. R⁶ can independently be a group selected from methyl groups and phenyl groups.

Furthermore, examples of the component (c1-1) include organohydrogenpolysiloxanes expressed by the following average formula (3).

(HR⁷₂SiO_{1/2})ᵢ(R⁷₂SiO_{2/2})ⱼ(R⁸SiO_{3/2})ₖ (3)

In formula (3), R⁷ and R⁸ each independently represent an unsubstituted or substituted monovalent hydrocarbon group that does not contain an aliphatic unsaturated bond with 1 to 12 carbon atoms, 10 mol% or more of all R⁸s represent aryl groups, and i, j, and k represent values that satisfy the conditions of 0.01 ≤ i ≤ 0.6, 0 ≤ j ≤ 0.9, 0.2 ≤ k ≤ 0.9, and i + j + k = 1.
Specific examples of the monovalent hydrocarbon group include the same as those indicated as specific examples of the monovalent hydrocarbon group expressed by R⁴ in average compositional formula (1) above. R⁸ can independently represent a group selected from methyl groups and phenyl groups, provided that 10 mol% or more of all R⁸ are phenyl groups.

The organohydrogenpolysiloxane expressed by the average compositional formula (2) above and the organohydrogenpolysiloxane expressed by the average compositional formula (3) may be used independently or in combination.

The amount of the organohydrogenpolysiloxane of the component (c1-1) in the curable silicone composition of the present invention is an amount sufficient to cure the curable silicone composition. The amount of hydrogen atoms bonded to a silicon atom in the organohydrogenpolysiloxane of the component (c1-1) is an amount where the number of silicon atom-bonded hydrogen atoms per alkenyl group for alkenyl groups bonded to silicon atoms included in the entire curable silicone composition is 0.5 to 20.0, and particularly within a range of 1.0 to 10, with regard to the curing reactive functional groups (such as vinyl groups or other alkenyl groups) containing a carbon-carbon double bond in the component (A) and the component (B) (hereinafter referred to as "SiH/Vi ratio").

Examples of the catalyst (c1-2) for the hydrosilylation reaction that is a part of the component (c1) include platinum-based catalysts, rhodium-based catalysts, and palladium-based catalysts. Platinum-based catalysts are preferred due to the ability to remarkably promote curing of the present composition. Exemplary platinum-based catalysts include platinum fine powder, chloroplatinic acid, an alcohol solution of chloroplatinic acid, a platinum-alkenyl siloxane complex, a platinum-olefin complex, a platinum-carbonyl complex, and a catalyst in which these platinum-based catalysts are dispersed or encapsulated with a thermoplastic resin such as silicone resin, polycarbonate resin, acrylic resin, or the like, with a platinum-alkenyl siloxane complex particularly preferable. Exemplary alkenylsiloxanes include: 1,3-divinyl-1,1,3,3-tetramethyldisiloxane; 1,3,5,7-tetramethyl-1,3,5,7-tetravinylcyclotetrasiloxane; alkenyl siloxanes obtained by substituting a portion of the methyl groups of the alkenylsiloxanes with an ethyl group, a phenyl group, or the like; and alkenylsiloxanes obtained by substituting a portion of the vinyl groups of these alkenylsiloxanes with an allyl group, a hexenyl group, or the like. In particular, 1,3-divinyl-1,1,3,3-tetramethyldisiloxane is preferably used because of the favorable stability of this platinum-alkenylsiloxane complex, and is preferably added in the form of a complex alkenylsiloxane solution. In addition, in terms of improving the handleability as well as the pot life of the composition, a platinum containing hydrosilylation reaction catalyst in microparticles dispersed and encapsulated with thermoplastic resin may be used. It should be noted that as the catalyst for promoting the hydrosilylation reaction, a non-platinum-based metal catalyst such as iron, ruthenium, iron/cobalt, or the like may be used.

From the viewpoint of its ability to improve the preservation stability of the curable silicone composition of the present invention, the component (c1-2) may be a hydrosilylation reaction catalyst that exhibits activity in a composition by being irradiated with a high energy beam. Hereinafter, such catalysts (c1-2L) for hydrosilation reaction are sometimes referred to as photo-activated-type "catalysts for hydrosilation reaction."

Specific examples of the photo-activated-type catalysts for hydrosilation reaction include (methylcyclopentadienyl) trimethyl platinum (IV), (cyclopentadienyl) trimethyl platinum (IV), (1,2,3,4,5-pentamethyl cyclopentadienyl) trimethyl platinum (IV), (cyclopentadienyl) dimethylethyl platinum (IV), (cyclopentadienyl) dimethylacetyl platinum (IV), (trimethylsilyl cyclopentadienyl) trimethyl platinum (IV), (methoxycarbonyl cyclopentadienyl) trimethyl platinum (IV), (dimethylsilyl cyclopentadienyl) trimethylcyclopentadienyl platinum (IV), trimethyl (acetylacetonato) platinum (IV), trimethyl (3,5-heptanedionate) platinum (IV), trimethyl (methylacetoacetate) platinum (IV), bis(2,4- pentanedionato) platinum (II), bis(2,4-hexanedionato) platinum (II), bis(2,4-heptanedionato) platinum (II), bis(3,5-heptanedionato) platinum (II), bis(1 -phenyl-1,3-butanedionato) platinum (II), bis(1,3-diphenyl-1,3-propanedionato) platinum (II), and bis(hexafluoroacetylacetonato) platinum (II). Of these, (methylcyclopentadienyl) trimethyl platinum (IV) and bis(2,4-pentanedionato) platinum (II) are preferred from the perspective of versatility and ease of acquisition.

In addition, examples of high energy beams include ultraviolet light, gamma rays, X-rays, alpha rays, electron beams, and the like. In particular, examples include ultraviolet light, X-rays, and electron beams irradiated from a commercially available electron beam irradiating device. Of these, ultraviolet rays are preferable from the perspective of efficiency of catalyst activation, and ultraviolet rays within a wavelength range of 280 to 380 nm are preferable from the perspective of industrial use. Furthermore, the irradiation dose varies depending on the type of high energy beam activated catalyst, but in the case of ultraviolet light, the integrated irradiation dose at a wavelength of 365 nm is preferably within a range of 100 mJ/cm² to 100 J/cm².

The added amount of component (c1-2) is a catalytic amount. Specifically, the amount is preferably such that the amount of metal atoms in component (D) is preferably in a range of 1 to 500 ppm, and more preferably in a range of 2 to 200 ppm, in mass units, with respect to the whole composition.

Organic peroxide as the component ( c 2) is a component that cures component (A) and component (B) described above by heating or irradiation with a high energy beam, and examples include alkyl peroxides, diacyl peroxides, ester peroxides, and carbonate peroxides.

Examples of alkyl peroxides include dicumyl peroxide, di-tert-butyl peroxide, di-tert-butylcumyl peroxide, 2,5-dimethyl-2,5-di(tert-butylperoxy)hexane, 2,5-dimethyl-2,5-di(tert-butylperoxy)hexyne-3, tert-butylcumyl, 1,3-bis(tert-butylperoxyisopropyl)benzene, and 3,6,9-triethyl-3,6,9-trimethyl-1,4,7-triperoxonan.

Examples of diacyl peroxides include benzoyl peroxide, methylbenzoyl peroxide, lauroyl peroxide and decanoyl peroxide.

Examples of ester peroxides include 1,1,3,3-tetramethylbutylperoxyneodecanoate, α-cumylperoxyneodecanoate, tert-butylperoxyneodecanoate, tert-butylperoxyneoheptanoate, tert-butylperoxypivalate, tert-hexylperoxypivalate, 1,1,3,3-tetramethylbutylperoxy-2-ethylhexanoate, tert-amylperoxyl-2-ethylhexanoate, tert-butylperoxy-2-ethylhexanoate, tert-butylperoxyisobutyrate, di-tert-butylperoxyhexahydroterephthalate, tert-amylperoxy-3,5,5-trimethylhexanoate, tert-butylperoxy-3,5,5-trimethylhexanoate, tert-butylperoxyacetate, tert-butylperoxybenzoate, and di-butylperoxytrimethyladipate.

Examples of carbonate peroxides include di-3-methoxybutyl peroxydicarbonate, di(2-ethylhexyl)peroxydicarbonate, diisopropyl peroxycarbonate, tert-butyl peroxyisopropylcarbonate, di(4-tert-butylcyclohexyl)peroxydicarbonate, dicetyl peroxydicarbonate, and dimyristyl peroxydicarbonate.

This organic peroxide preferably has a 10-hour half-life temperature of no lower than 65°C, no lower than 75°C, or no lower than 90°C. Examples of such organic peroxides include methylbenzoyl peroxide, dicumyl peroxide, di-tert-butyl peroxide, di-tert-hexyl peroxide, tert-butylcumyl peroxide, 2,5-dimethyl-2,5-di(tert-butylperoxy)hexane, 1,3-bis(tert-butylperoxyisopropyl)benzene, di-(2-tert-butylperoxyisopropyl)benzene, and 3,6,9-triethyl-3,6,9-trimethyl-1,4,7-triperoxonan.

While not limited thereto, the content of the (c2) organic peroxide is preferably within the range of 0.05 to 10 mass parts, or within the range of 0.10 to 5.0 mass parts, with regards to 100 mass parts of component (A) and component (B).

The component (C) can be appropriately selected from the specific examples described above, but it is necessary that the component (C) can be applied to a production method of the composition of the present invention and a wafer backside lamination process described below. From the viewpoint of the method for producing the present composition, it is necessary that the curing reaction does not proceed by heat applied during production of the composition. In the case of using a hydrosilylation reaction, it is preferable that the catalyst is activated in response to some stimulus such as heat at 100°C or higher or high energy beam. Similarly, in the case of organic peroxide curing, the temperature at which the half-life of the catalyst becomes 10 hours is preferably a certain temperature or higher.

On the other hand, what is required when the dicing tape is applied to a wafer backside lamination process, which will be described later, is a process of curing the dicing tape by irradiation with a high energy beam or the like and peeling the dicing tape from the surface of the curable silicone composition according to the present invention. **The** process requires irradiation with a high energy beam. Hence, if a photoactivatable hydrosilylation catalyst that can be activated under the same conditions as the wavelength and irradiation amount of the required high energy beam can be selected, the photoactivatable hydrosilylation catalyst can be activated in the same step. Consequently, there is an advantage concerning the steps that the step of additionally irradiating with a high energy beam can be omitted. In addition, when a photo-active hydrosilylation catalyst is used as the component (C), the curing reaction of the present composition does not easily proceed at room temperature even after the catalyst is activated. Therefore, it is possible to continue the wafer backside lamination process without causing an unintended curing reaction or adhesion.

### [Component (D)]

The aerosol silica (= fumed silica) as the component (D) is one of the characteristic components of the present invention, and on the premise that the mass ratio of the component (A) to the component (B) (i.e., (A)/(B)) is in a range of 2.50 to 3.00, when the content of the component (D) is in a range of 2.0 to 10 mass%, preferably in the range of 3.0 to 9.0 mass%, based on the total amount of the components (A) to (D), the adhesive properties of the resultant curable silicone composition at room temperature is reduced. Temporary fixing by an uncured dicing tape having good adhesiveness is still possible, but once the dicing tape is cured by irradiation with a high-energy beam or the like, the adhesive strength is reduced, and easy peelability can be realized. Here, when the content of the component (D) is less than the lower limit, the temporary fixing and easy peelability become insufficient. On the other hand, if the content of the component (D) exceeds the upper limit, the curable silicone composition and the dicing tape cannot be adhered to each other, and temporary fixing or the yield at the time of dicing may be worsened. In addition, the hot-melt characteristics of the entire composition may be worsened.

The aerosol silica as the component (D) is a typical dry silica obtained by hydrolyzing silicon tetrachloride as a raw material in a flame of oxygen and hydrogen. A large number of products having different particle diameters and BET specific surface areas have been designed by changing production conditions such as the temperature of the flame and the supply ratio of raw material/oxygen/hydrogen. Further, aerosol silica combined with fumed titania or fumed alumina is also provided by using other chlorinated metallic compounds (TiCl₄, AlCl₃, etc.) in combination also as raw materials.

The aerosol silica (D) is not particularly limited, but has a mean primary particle size of 5 to 50 nm, a BET specific surface area of 50 to 400 m²/g, and no internal specific surface area because it has no pores inside. The aerosol silica as the component (D) may form secondary particles by aggregation. In the present invention, when dry silica other than aerosol silica or other wet silica is used instead of the component (D), even if the amount of use thereof is within the above range, the adhesive strength to the dicing tape is greatly reduced, and/or easy peelability may not be realized. However, it is not prevented to use dry silica other than the aerosol silica or other wet silica in combination within a range not impairing the technical effects of the present invention.

The aerosol silica (D) is preferably an aerosol silica having a BET specific surface area of 100 m²/g or greater, preferably a BET specific surface area in a range of 125 to 300 m²/g and surface-treaded with (D1) one or more silicon-containing compounds selected from organoalkoxysilanes, organohalosilanes, organosilazanes, and siloxane oligomers. Some examples of silicon-containing compounds used for the surface treatment of aerosol silica are organoalkoxysilanes such as methyltrimethoxysilane and dodeciltrimethoxysilane; organohalosilanes such as trimethylchlorosilane; organosilazanes such as hexamethyldisilazane; siloxane oligomers such as dimethylsiloxane oligomers capped with α,ω-silanol groups, methylphenylsiloxane oligomers capped with α,ω-silanol groups, methylvinylsiloxane oligomers capped with α,ω-silanol groups, or the like. In particular, hydrophobic aerosol silica surface-treated with a silylating agent, organosilazane (suitably one or more selected from hexamethyldisilazane and tetramethyldivinyldisilazane) is a particularly favorable example. The aerosol silica as the preferred ingredient (D) is commercially available from Nippon Aerosil Co., Ltd., and examples thereof include aerosol silica treated with hexamethyldisilazane [manufactured by Nippon Aerosil Co., Ltd., trade name: Aerosil RDX200 (BET specific surface area 200 ma₂/g)], but the aerosol silica is not limited thereto. Two or more kinds of aerosol silica having different particle sizes and different BET specific surface areas may be used in combination.

### [Hydrosilylation Reaction Curing Retarder]

In addition to components (A) to (D) above, the curable silicone composition of the present invention may further contain a hydrosilylation reaction curing retarder. The structure of the curing retarder is not particularly limited, but when melting and kneading raw materials under reduced pressure in the production process of curable silicone compositions, use of (E) a hydrosilylation reaction curing retarder with a boiling point of 200°C or higher under atmospheric pressure is particularly preferred. If a compound with a low boiling point is used as a curing retarder, a portion or all of the curing retarder may volatilize during the melting and kneading process, and thus a targeted effect of the curing retarding effect may not be achieved with the curable silicone composition.

The cure retarding agent of the present invention is not particularly limited, and examples include: 2-methyl-3-butyne-2-ol, 3,5-dimethyl-1-hexyne-3-ol, 2-phenyl-3-butyne-2-ol, 1-ethynyl-1-cyclohexanol, and other alkyne alcohols; 3-methyl-3-pentene-1-yne, 3,5-dimethyl-3-hexene-1-yne, and other enyne compounds; tetramethyltetravinylcyclotetrasiloxane, tetramethyltetrahexenylcyclotetrasiloxane, and other alkenyl group-containing low molecular weight siloxanes; and methyl tris(1,1-dimethyl propynyloxy)silane, vinyl tris(1,1-dimethyl propynyloxy)silane, and other alkynyloxysilanes. Of these, the use of (E) a curing retarder with a boiling point of 200°C or higher under atmospheric pressure is particularly preferred, and for practical use, the use of alkynyloxysilanes such as methyl-tris(1,1-dimethylpropynyloxy)silane and vinyl-tris(1,1 dimethylpropynyloxy)silane, and the like is preferred. The amount of the curing retarder in the curable silicone composition is not particularly limited, but is preferably within a range of 1 to 10,000 ppm in mass units, with regard to the composition.

### [(F) Other Additives]

In addition to the above components (A) to (D) and optional component (E), materials known in the art as additives that may be used in a silicone composition may be added to the curable silicone composition of the present invention. Herein, the additives that can be used include, but are not limited to, the following. Note that when melting and kneading raw materials under reduced pressure in the production process of the curable silicone composition and based on the technical effects of the present invention, it is particularly preferable that the other additives have a high boiling point or be a component that is substantially non-volatile.

### [(F1) Functional Filler]

A functional filler that is different from the component (D) can be used as an additive in order to improve the mechanical properties of a cured product obtained from the curable silicone composition of the present invention, to improve flame retardancy, or the like. Examples of these functional fillers include inorganic fillers, organic fillers, and mixtures thereof. Examples of the inorganic fillers include reinforcing fillers, pigments (particularly white pigments and black pigments), thermally conductive fillers, electrically conductive fillers, phosphors, and mixtures of at least two of these, and examples of organic fillers include a silicone resin filler, a fluorine resin filler, and a polybutadiene resin filler. Note that the shape of these fillers is not particularly limited and may be spherical, spindle-shaped, flat, needle-shaped, amorphous, or the like. In addition, these components are used within a range that does not impair the object of the present invention.

### [(F2) Adhesion Imparting Agent]

The composition of the present invention may contain an adhesion imparting agent so long as the object of the present invention is not impaired. Such adhesion imparting agents are common to components suitably exemplified by the present applicant in International Patent Application Publication WO2020/203304, and reaction mixtures of epoxy group-containing organoalkoxysilane and amino group-containing organoalkoxysilane disclosed in Japanese Examined Patent Publication S52-8854 and Japanese Unexamined Patent Application H10-195085, and particularly carbasilatrane derivatives having a silicon atom-bonded alkoxy group or silicon atom-bonded alkenyl group in one molecule, silatrane derivatives having an alkoxysilyl group-containing organic group, and the like can be preferably used in addition to 3-glycidoxypropyltrimethoxysilane and other silane compounds, organosiloxane oligomers, and alkyl silicates. The amount of the adhesion imparting agent is not limited, but is preferably within a range of 0.01 to 10 parts by mass relative to 100 parts by mass total of the present composition.

### [Other Optional Components]

Furthermore, the composition may contain, as other optional components, heat resistance agents such as iron oxide (red iron oxide), cerium oxide, cerium dimethyl silanolate, fatty acid cerium salt, cerium hydroxide, zirconium compound, and the like; and in addition, dyes, pigments, flame retardancy imparting agents, and the like. Furthermore, if desired, from the viewpoint of further improving the melting characteristics, hot-melt particles (e.g., hot-melt particles made of metallic stearate or the like) having a dropping point of 50°C or higher and a melt viscosity of 10 Pas or lower as measured at 150°C by a rotational viscosity meter may be added.

### [Sheet-like or Film-like Shaped Product]

The curable silicone composition according to the present invention can be suitably used for die attach film applications, and is particularly preferably used by being shaped into a film-like shape or a sheet-like shape. For example, a sheet made of a curable silicone composition shaped into a sheet or film having an average thickness of 10 to 2,000 µm is advantageous because it has hot-melt properties and heating-curability at high temperatures. Hence, such a sheet demonstrates particularly excellent handleability and melting characteristics when used as a die attach film. In the present specification, both the "sheet" and the "film" represent a substantially uniform and flat thin plate-like shaped product, and the "curable silicone composition sheet" includes both a thin film-like film and a sheet having a certain thickness.

### [Method for Producing Curable Silicone Composition Sheet]

The method for producing the curable silicone composition sheet according to the present invention is not particularly limited, but
Production method (I): a production method including a step of melting and kneading the entire curable silicone composition within a temperature range of 50°C to 100°C and shaping the composition into a sheet or a film having a thickness of 10 to 2000 µm; and
Production method (II): a production method including a step of dissolving the entire curable silicone composition in an organic solvent, then applying the solution onto a substrate having a peeling surface, and drying the organic solvent at a temperature not exceeding 100°C to shape a sheet or a film having a thickness of 10 to 2000 µm
may be used as suitable method.

More specifically, the production method (I) includes the following Steps 1 to 3 and an optional cutting step, and for example, the same method as the method for producing a curable silicone sheet proposed by the present applicant in paragraphs [0086] to [0105] of International Patent Application (PCT/JP2022/31578) (including a preferred use of a continuous heating and kneading device such as a twin-screw extruder) may be used.
Step 1: Kneading the components of the curable silicone composition while heating and melting in the temperature range of 50°C to 100°C
Step 2: Laminating the heat-melted mixture obtained in step 1 between films with at least one peeling surface
Step 3: Stretching the laminate obtained in step 2 between rolls to form a curable silicone sheet with a specific film thickness
Cutting step: Optionally cutting the laminate including the curable silicone sheet

The production method (II) is a shaping step using an organic solvent, and includes a step of uniformly dispersing the curable silicone composition according to the present invention in an organic solvent using a mechanical force. While the mixing apparatus using a mechanical force is not limited, the mixing apparatus may be: a batch type heating and kneading apparatus (provided with a heating/cooling function) such as a kneader, a Banbury mixer, a Henschel mixer, a planetary mixer, a 2-roll mill, a 3-roll mill, a Ross mixer, or a labo Plastomill; or a continuous type heating and kneading apparatus (provided with a heating/cooling function) such as a single screw extruder or a twin screw extruder. Furthermore, the type of the organic solvent is not particularly limited, but an organic solvent having a boiling point of 80°C or higher but of 200°C or lower is preferably used. The type of solvent can be a non-halogenated or halogenated solvent, aromatic hydrocarbon solvent, aliphatic hydrocarbon solvent, ester solvent, alcohol solvent, ether solvent, chlorinated aliphatic hydrocarbon solvent, volatile oil solvent, or the like, and combinations of two or more types can be used depending on the coatability, wettability, and the like. From the viewpoint of dispersibility of the silicone component, toluene or xylene is preferably used.

In the production method (II), the organic solvent dispersion of the coatable curable silicone composition is applied onto a sheet-shaped substrate having a peeling surface. Examples of application methods include gravure coating, offset coating, offset gravure, roll coating, reverse roll coating, air knife coating, curtain coating, and comma coating. The coating amount can be designed at a desired thickness, for example, can be designed at a thickness of the dried composition sheet after the removal of the organic solvent in a range from 10 to 2000 µm. The thickness may range from 10 to 1000 µm, or from 10 to 900 µm or 10 to 200 µm, but the thickness is not limited thereto.

While the thickness of the sheet-like substrate with a peeling surface is not particularly limited, but it is within a range from 5 to 300 µm. Exemplary types of such substrate include paperboard, cardboard paper, clay-coated papers, polyolefin laminate papers, particularly polyethylene laminate papers, synthetic resin films and sheets including polyethylene terephthalate (PET), natural fiber woven materials, synthetic fiber woven materials, artificial leather woven materials, and metal foils. Particularly preferred are synthetic resin films and sheets. In addition, the peeling surface may also be referred to as a peeling liner, a separator, a peeling layer, or a peeling coating layer and may preferably be a peeling surface having a peeling coating ability such as a silicone-based peeling agent, a fluorine-based peeling agent, an alkyd-based peeling agent, a fluorosilicone-based peeling agent, or the like, or may be formed as a substrate itself which is not prone to adhering to the hot-melt curable silicone sheet of the present invention by forming physically fine irregularities in the surface of the substrate.

In the production method (II), the organic solvent is removed by drying from the organic solvent dispersion of the curable silicone composition applied onto the sheet-shaped substrate having a peeling surface at a temperature range not exceeding 100°C. Thus, the curable silicone composition sheet can be obtained. The drying means is not particularly limited, and the drying can be performed in a hot air circulation type oven set to a temperature of lower than 100°C, for example, in a range of 30 to 80°C. Here, the drying temperature is preferably set to a low temperature of less than 100°C within a range that does not prevent drying to dryness. When drying is performed at a high temperature, the preservation stability may be impaired due to the progress of the curing reaction by the activation of an unintended curing agent (e.g., a photo-active hydrosilylation reaction catalyst or the like) in the hot-melt curable silicone composition. Optionally, a curable silicone composition sheet having a desired thickness may be designed by using a known rolling method such as roll rolling by preparing a laminate by interposing a curable silicone composition sheet between two sheet-shaped substrates each having a peeling surface.

The curable silicone composition sheet according to the present invention has hot-melt properties and exhibits adhesive and bonding properties when heated and melted, so it has excellent moldability, gap-filling properties, and adhesive strength, and can be used as a die attach film, film adhesive, and film sealant. It is also suitable for use as a curable silicone sheet for compression molding, press molding, and vacuum lamination.

Specifically, the curable silicone composition sheet according to the present invention may be peeled from the peelable film, the disposed at a desired site such as a semiconductor. Subsequently, a film adhesive layer that utilizes gap filling properties with respect to irregularities or gaps may be formed on an adherend, then temporarily fixed, disposed, and applied together between the adherends. Further, the curable silicone sheet may be heated to at least 150°C and adhered between the adherends by the cured product of the curable silicone sheet. Note that the peelable film may be released after heating the curable silicone sheet and forming a cured product, wherein the release timing may be selected according to the application and use method of the curable silicone sheet.

Because the curable silicone composition sheet has hot-melt properties, it is possible to soften or fluidize the sheet by heating the sheet prior to final curing and, for example, thereby forming the adhesive surface by filling any unevenness or gaps so as not to have any gaps even if there are irregularities on the attached surface of the adherend. Exemplary heating means of the curable silicone sheet include various thermostatic baths, hot plates, electromagnetic heating apparatuses, heating rolls, etc. In order to perform application and heating more efficiently, for example, an electric heat press, a diaphragm type laminator, a roll laminator, etc. are preferably used.

### [Use as Semiconductor Device and Die Attach Film]

As described above, the curable silicone composition sheet according to the present invention has excellent shapability, gap filling properties, and adhesive strength, and is used for the purpose of bonding a semiconductor chip or a semiconductor wafer to a mounting portion therefor. The curable silicone composition sheet can also be used for the production of a semiconductor device as a die attach film or a film adhesive, and is particularly preferably used for a die attach film that is used for a MEMS device. Herein, "MEMS device" is a generic term for a semiconductor device formed using semiconductor microfabrication technology, commonly called Micro Electro Mechanical Systems, and may be an inertial sensor such as an acceleration sensor, angular rate sensor, or the like provided with an MEMS chip. Furthermore, a known semiconductor device can be used without particular limitation, and examples include diodes, transistors, thyristors, monolithic ICs, hybrid ICs, LSIs, and VLSIs. The curable silicone composition or the cured product thereof according to the present invention can be suitably used in applications of disposing (temporarily securing) a semiconductor chip of the semiconductor devices mentioned above (including MEMS devices) to a chip attachment part, and then permanently adhering/bonding the chip by heating or the like.

In particular, when used in combination with a dicing tape having a property of reducing the adhesive strength by irradiation with a high energy beam, the curable silicone composition sheet according to the present invention exhibits sufficient adhesiveness to the uncured or B-staged dicing tape exhibiting adhesive strength, and can perform sufficient temporary fixing during dicing. On the other hand, when the dicing tape is cured by irradiation with a high energy beam or the like to reduce the adhesive strength, the adhesive strength to the curable silicone composition reduces by at least 30% or more, and the sheet becomes easily peelable. It should be noted that the curing reaction of the composition of the present invention does not immediately proceed at room temperature even after irradiation with a high energy beam. Hence, the composition as a whole has hot-melt properties and curing reactivity even after peeling from the dicing tape which has become unnecessary after the dicing operation. Therefore, the composition can be adhered after disposing the individual piece of the individualized wafer for a semiconductor on the substrate of the semiconductor, and is particularly useful as a die attach film used in the manufacturing process of the semiconductor device.

More specifically, the curable silicone composition sheet according to the present invention or a cured product thereof may be laminated on a semiconductor member such as a semiconductor wafer or a semiconductor chip used in the semiconductor device. The method of lamination is not particularly limited, but the curable silicone composition sheet according to the present invention does not exhibit adhesive properties under conditions where no pressure is applied to the surface thereof. The curable silicone composition sheet according to the present invention, however, has hot-melt properties and curability, and therefore lamination is preferably carried out by a method selected from direct lamination, pressure-bonding, and pressure bonding with heating. While a semiconductor member of the semiconductor wafer or semiconductor chip provided with the silicone-based adhesive sheet is in a laminate, the semiconductor member can be separated into individual pieces using known means such as dicing or the like, and can be arranged (mounted) on an attachment part on the semiconductor substrate such as a die pad or the like as a semiconductor chip (die) provided with the silicone-based adhesive sheet of the present invention. Furthermore, at that time, the curable silicone composition sheet according to the present invention of the attachment part has certain adhesion properties that is responsive to the pressure, and thus the semiconductor chip (die) can easily be temporarily secured on the semiconductor substrate within a very short pressure-bonding time. Moreover, there is an advantage in which misalignment or peeling off are less likely to occur with regard to vibrations and the like. The silicone composition sheet can finally bond or join a semiconductor chip (die) and a semiconductor substrate by a curing reaction caused by at least one or more curing stimuli selected from heating and irradiation with high energy beam. Thus obtained is a semiconductor device in which both are firmly bonded.

The material and the like of the semiconductor base material is not particularly limited, but may be an essentially flat plate. Furthermore, although not particularly limited, examples of the material thereof include semiconductor chips, aluminum, iron, zinc, copper, magnesium alloys, and other metals, ceramics, glass, epoxy resins, polyimide resins, phenol resins, Bakelite resins, melamine resins, glass fiber reinforced epoxy resin, acrylic resin, ABS, SPS and other plastics, and glass. While not particularly limited thereto, the thickness of the base material may be 0.1 to 10 mm. Note that these are non-adhesive base materials that do not have pressure-sensitive adhesive properties on their own.

### [Peelablee laminate]

The curable silicone composition sheet according to the present invention may be in the form of a peelable laminate having a structure in which the curable silicone composition sheet is sandwiched between sheet-like substrates having peeling surfaces facing respectively both surfaces of the curable silicone composition sheet.

By removing the sheet-shaped substrate having a peeling surface from only one surface of the peelable laminate to expose the surface of the curable silicone composition sheet, and bringing the dicing tape into close contact with the one surface of the curable silicone composition sheet,
a peelable laminate can be obtained which comprises: (L1) a dicing tape having a property of reducing an adhesive strength caused by irradiation of a high energy beam;
(L2) a layer comprising a curable silicone composition closely adhered to one surface of the dicing tape; and
(L3) a sheet-like substrate having a peeling surface facing the layer comprising a curable silicone composition.

### [Laminate as Member for Semiconductor or Precursor for Semiconductor]

In the peelable laminate having the (L1) to (L3) layers, by removing the sheet-shaped substrate having a peeling surface, which is the (L3) layer, to expose the curable silicone composition sheet surface and bringing the semiconductor wafer or the semiconductor chip into close contact with the curable silicone composition sheet surface;
a laminate can be obtained which comprises: (L1) a dicing tape having a property of reducing an adhesive strength caused by irradiation of a high energy beam;
(L2) a layer comprising a curable silicone composition closely adhered to one surface of the dicing tape; and
(W) a semiconductor wafer or a semiconductor chip, at least part of which is closely adhered to the layer comprising the curable silicone composition.
Such a laminate is useful, as a member for semiconductor or a precursor for semiconductor, in the method for producing a semiconductor device, which method will be described later.

As the dicing tape, a commercially available dicing tape can be used, and in the present invention, a combination with a dicing tape having a property of reducing the adhesive strength caused by irradiation with a high energy beam is preferred. Specifically, a UV curable stretch tape is available on the market, and the dicing tape itself is in an uncured or B-stage state and has a strong adhesive strength. UV curing, however, proceeds by irradiation with a high energy beam, and the adhesive strength is significantly reduced. The curable silicone composition of the present invention exhibits almost no adhesive properties but easily adheres to an adherend when pressure is applied, and therefore can be easily adhered to a dicing tape exhibiting a certain degree of adhesive properties. On the other hand, once the dicing tape is adhered to the dicing tape, it is difficult to peel off, in a easy manner, the dicing tape which is no longer necessary after dicing. Hence, it is preferable to use a UV curable dicing tape and to peel off the UV curable dicing tape by reducing the adhesion strength caused by stimulation of a high energy beam. As a commercially available product, for example, Adwill D series manufactured by LINTEC Corporation can be applied.

The curable silicone composition according to the present invention is not cured in a short time at room temperature regardless of the presence or absence of irradiation with high-energy beam. Therefore, even though the curable silicone composition has been subjected to the process from temporary fixing to pickup using a UV-curable dicing tape, the hot-melt properties and curing reactivity thereof are not lost, and a certain level of adhesive properties are exhibited in response to a pressure. Therefore, after the dicing tape is peeled off, the individual pieces of the semiconductor wafer that have been separated into individual pieces can be temporarily fixed on the semiconductor substrate and then bonded there.

Therefore, with respect to the laminate including the (L1), (L2), and (W) layers described above, a dicing tape is fixed, semiconductor wafers or the like are separated into individual pieces (diced), and then a high energy beam is irradiated from the (L1) side to cure the dicing tape and reduce the adhesive strength thereof, thereby easily removing only the (L1).
As a result, a laminate comprising: (L2C) a layer comprising the curable silicone composition obtained by peeling, from the surface thereof, the dicing tape irradiated with a high energy beam; and
(W) a individualized chip for semiconductors, at least a part of which is closely adhered to the layer (L2C layer) comprising the curable silicone product.
Such a laminate is useful, as a member for semiconductor or a precursor for semiconductor, in the method for producing a semiconductor device, which method will be described later.

Here, when a photo-active catalyst for hydrosilylation reaction is used as the component (C) of the curable silicone composition of the present invention, the catalyst is activated in the step of curing the dicing tape, and thereafter, the curable silicone composition is in a state of being curable only by heat. Even if the photo-active hydrosilylating reaction is activated, the present composition hardening reaction does not proceed at room temperatures and in a short time. So, it is possible to form a (L2C) layer that does not lose its hot-melt properties and hardening reactivity.

Such a laminate is a precursor or a member of the semiconductor device (particularly, MEMS device and the like), and is simply a laminate having a structure in which a semiconductor chip or a wafer for semiconductor is disposed on a substrate via the curable silicone composition sheet. The laminate may be a precursor of a semiconductor device having a structure in which semiconductor chips (die) individualized by dicing are arranged on a circuit board such as a die pad or the like via the silicone-based adhesive sheet described above and temporarily retained (temporarily secured), and in particular, may be a precursor of a MEMS device. By heating the entire laminate to, for example, 50°C or higher, preferably to a temperature at which the curable silicone composition sheet exhibits hot-melt properties or higher, and pressure-bonding the laminate, a semiconductor device (preferably a MEMS device) having a structure in which a semiconductor chip or a semiconductor wafer is fixed onto a substrate by the curable silicone composition sheet or a cured product thereof can be obtained. The heating temperature and heating time for bonding, and the presence or absence of pressure bonding can be appropriately selected by controlling the curing characteristics of the composition of the present invention.

The semiconductor device (especially MEMS device, or the like) may further be provided with circuit wiring, bonding wires or bumps for connecting chips and circuit wiring, resin layers that encapsulate a portion or all of the circuit wiring or chips, and the like, and can be suitably designed according to the type or application of the semiconductor device. Furthermore, the semiconductor device may have a horizontally arranged structure, a vertically arranged structure, or a three-dimensionally stacked structure. Once pressure-bonded, the curable silicone composition sheet described above has a great fixing strength, which enables temporary fixing and repositioning even in arrangements other than the horizontal direction, and once temporarily fixed to the designed attachment site, the sheet is resistant to misalignment even when subjected to shocks and vibrations associated with other wiring and the like. By heating the semiconductor device precursor as it is, the curable silicone composition sheet having hot-melt properties is thermally melted to exhibit good gap filling properties and hardening properties (including secondary hardening properties), and thus can easily adhere a chip or the like to a semiconductor substrate, thus providing a benefit of being flexibly adaptable to various semiconductor device designs and manufacturing processes, in particular for a case where the semiconductor substrate has a irregular surface.

### [Semiconductor Device Manufacturing Method]

As described above, the curable silicone composition sheet having hot-melt properties according to the present invention can be suitably used as a die attach film in a method for producing a semiconductor device including a wafer back side lamination step for a semiconductor. The method includes a temporary fixing step with a dicing tape and an individualizing (dicing) step. In the method, the dicing tape that has become unnecessary after dicing is removed easily because of the easy peeling of the dicing tape to expose a silicone layer having hot-melt properties and curability that serves as an adhesive or bonding layer. In addition, the individualized semiconductor chips are disposed (including temporary fixing) on a semiconductor substrate, and finally, both can be firmly bonded.

Specifically, a method of manufacturing a semiconductor device according to the present invention includes the steps of:
(1) laminating, onto a back surface of a semiconductor wafer, a sheet or film comprising the above-described curable silicone composition, with one surface of which sheet or film a dicing tape is in close contact, the dicing tape having a property of reducing an adhesive strength caused by irradiation with a high energy beam;
(2) dicing and thereby individualizing a resultant laminate from the step (1);
(3) irradiating the dicing tape with a high energy beam and thereby reducing the adhesive strength of the dicing tape;
(4) peeling off the dicing tape from the one surface of the curable silicone composition whose adhesive strength to the dicing tape has been reduced in the step (3);
(5) disposing an individual piece of the semiconductor wafer on a semiconductor substrate via the resultant curable silicone composition from the step (4); and
(6) performing a curing reaction that includes heating a resultant structure from the step (5) with the individual piece of the semiconductor wafer disposed on the semiconductor substrate and thereby bonding the individual piece of the semiconductor wafer onto the semiconductor substrate.

It is particularly preferable that the step (6) includes a step of heating and pressure-bonding the curable silicone composition having hot-melt properties in a range of 50 to 200°C.

The step (1) is a step of laminating a curable silicone composition sheet, to one surface of which a dicing tape having a property of reducing the adhesive strength by irradiation with a high energy beam is adhered, on the back surface of a semiconductor wafer, and is also a step of preparing a semiconductor wafer having a curable silicone composition sheet on at least one surface and a dicing tape on the opposite surface by means of pressure-bonding or the like. Note that in this case, an electrode or protective film may be formed on the wafer in advance if desired. Furthermore, after the curable silicone composition sheet is adhered, an excess of the sheet may be cut off.

The step (2) above is a so-called dicing step, and is a step of separating, into individual pieces (dies), a semiconductor wafer provided with the curable silicone composition sheet on one surface thereof. In the creation of an MEMS device, a semiconductor chip with a length and width of 10 mm or less, and preferably 5 mm or less, may be and is preferably created. In the step 2, dicing is performed by a dicer, and at this time, a temporary fixing tape, commonly called a dicing tape, is generally used. In the present invention, a three layer laminate composed of a dicing tape/a curable silicone composition sheet/a semiconductor wafer is formed as a temporary structure, and the curable silicone composition sheet has sufficient adhesiveness to temporarily fix the dicing tape, which is one of the advantages of the present invention. In the process of the present invention, it is preferable to use a UV-curable dicing tape because the adhesive strength can be greatly changed.

The step (3) is a pretreatment step for making the dicing tape, which has become unnecessary after the step 2, easily peelable from the curable silicone composition sheet. In order to establish the step (2) (dicing step) and subsequent step (5) (mounting step), the hot-melt curable silicone composition sheet needs to exhibit sufficient adhesiveness to the dicing tape (the step (2)), while the dicing tape that has become unnecessary needs to be smoothly peeled off after the dicing step. Specifically, since the dicing tape is UV-curable and the adhesive strength thereof changes significantly between before curing and after curing, the adhesive strength is reduced by 30% or more by irradiating the dicing tape side of the laminate with a high energy beam to cure the tape. Hence, the tape can be easily peeled off from the curable silicone composition of the present invention. The curing stimulus in the step (3) may be, in particular, irradiation with a high energy beam such as ultraviolet light (UV), and such irradiation is preferred.

The irradiation amount and the wavelength of the high energy beam in the above-mentioned step can be designed as appropriate. Use of a dicing tape is preferred that is cured by a trigger of an irradiation with a high-energy beam with a wavelength ranging from 280 to 410 nm, and with a ultraviolet light irradiation amount (irradiance) ranging from 100 mJ/cm² to 10,000 mJ/cm², and preferably 1,000 mJ/cm² to 5,000 mJ/cm² as the integrated light intensity. When a photo-activated hydrosilylation catalyst is used as the component (C) of the curable silicone composition of the present invention, the catalyst can be activated at the same time as the dicing tape is cured by matching the activation conditions for the catalyst and the curing conditions for the dicing tape. The obtained curable silicone composition can be a heat curable silicone composition that does not easily react at room temperature at the time of activation and the curing.

The peelability of the dicing tape (before and after the curing) from the curable silicone composition sheet can be simply evaluated by measuring the peel strength of a laminate in which the dicing tape and the curable silicone composition sheet are closely adhered to each other. In general, the peel strength between the dicing tape and the silicone sheet before the curing reaction (e.g., UV irradiation) is preferably 10N/20 mm or more, or 15N/20 mm or more, and the peel strength between the dicing tape and the silicone sheet after the curing (e.g., UV irradiation) is preferably 5N/20 mm or less, or 3N/20 mm

The step (4) is a step of peeling the dicing tape from the surface of the curable silicone composition whose adhesive strength to the dicing tape has been reduced in the step (3). This makes it possible to use, in the subsequent step (5), an adhesive surface composed of a curable silicone composition that has excellent temporary fixing properties by pressure-bonding, and that has hot-melt properties and further curability. As a result the curable silicon composition can firmly bond the individualized semiconductor chip and the semiconductor substrate.

Step 5 above is a so-called mounting step, and is a step in which the semiconductor chips (dies) that have been individualized by dicing are arranged on a circuit board such as a die pad or the like via the curable silicone composition described above to create a temporarily retained (temporarily secured) semiconductor precursor. Note that after the step, the semiconductor chip may be treated by sputtering, wiring with an electrode, or the like.

In the step (5), it is necessary to pick up a two layer laminate composed of a silicone sheet and a wafer from the three layer laminate composed of a dicing tape, a silicone sheet, and a wafer formed in the step (2), but as described above, the silicone sheet is smoothly peeled off from the dicing tape by the previous steps (steps 3 and 4) of this step.

The step (6) described above is a step of fixing (permanently bonding) the adherend with the cured product of the curable silicone composition, and the individual pieces of the wafer for semiconductor after dicing are bonded onto the semiconductor substrate by thermal curing of the cured product of the curable silicone composition having hot-melt properties. The conditions can be appropriately designed according to the selection of the component (C) of the composition and the desired process, but a step of pressure-bonding with heating the cured product of the curable silicone composition having hot-melt properties in a range of 50 to 200°C is particularly preferable. There is an advantage that the gap-fill property on the semiconductor substrate is excellent and a strong bonded body can be formed. The step (4) can simultaneously process a structure in which many individual pieces of the semiconductor wafer are arranged on the semiconductor substrate by the silicone-based adhesive sheet surface, and therefore has excellent industrial production efficiency and can easily mass-produce even fine and high-precision semiconductor devices such as MEMS devices. When the component (C) of the composition contains a catalyst that is activated by irradiation with a high energy beam (typically, a photo-active hydrosilylation reaction catalyst), the catalyst is activated at the time of curing the dicing tape in the step (3), and therefore, the curing can be completed only by applying heat in the step (6).

The method of manufacturing a semiconductor device of the present invention is provided with the steps 1 to 6 above. The method may include, if desired, a protective film formation step for the wafer, a wiring step for the semiconductor substrate, a chip and electrode connection step, a polishing step, a partial or total sealing step, or the like at any desired timing.

The silicone-based bonding sheet of the present invention may be used in the method for producing semiconductor devices (suitably, MEMS devices), the method having the following steps: This is a modification of the steps 1 to 5 described above, in which the laminate composed of the dicing tape and the curable silicone composition layer is first separated into individual pieces. The diced laminate is disposed on the semiconductor substrate, and the dicing tape is then peeled off. The semiconductor wafer piece is then disposed on the substrate, and a process for producing a semiconductor device that takes advantage of the properties of the curable silicone composition of the present invention can be designed. In the step of bonding the individual pieces of the semiconductor wafer onto the semiconductor substrate with the curable silicone composition (having hot-melt properties), it is particularly preferable to include a step of pressure-bonding with heating in a range of 50 to 200°C so that the advantageous gap fill characteristics can be utilized.

(1) individualizing, into a size approximate to a semiconductor chip, a sheet or film comprising a curable silicone composition, the sheet or film having a dicing tape closely adhered to one surface thereof, the dicing tape having a property of reducing an adhesive strength caused by irradiation with a high energy beam;
(2) disposing a sheet or film composed of a resultant individualized curable silicone composition from the step (1) on a semiconductor substrate;
(3) irradiating the dicing tape with a high energy beam and thereby reducing the adhesive strength of the dicing tape;
(4) peeling off the dicing tape from the one surface of the curable silicone composition whose adhesive strength to the dicing tape has been reduced in the step (3);
(5) disposing an individual piece of the semiconductor wafer on a semiconductor substrate via a resultant curable silicone composition from the step (4); and
(6) performing a curing reaction that includes heating a resultant structure from the step (5) with the individual piece of the semiconductor wafer disposed on the semiconductor substrate and thereby bonding the individual piece of the semiconductor wafer onto the semiconductor substrate.

### [Improving Production Efficiency of and Reliability of Semiconductor Device]

When the cured product obtained using the hot-melt curable silicone composition of the present invention is used as a permanent adhesive layer, it has a certain degree of elastomeric properties (flexibility). Therefore the cured product has an advantage of having more excellent stress relaxation properties than a synthetic resin sheet such as a conventionally known epoxy-based adhesive sheet or a general silicone cured product, and having excellent impact and stress relaxation properties with respect to a semiconductor chip (die) mounted on a semiconductor substrate. Furthermore, the hot-melt curable silicone composition sheet of the present invention has hot-melt properties, and therefore exhibits excellent gap filling properties with respect to a semiconductor substrate having a large number of irregularities. Hence, the sheet can firmly bond a semiconductor chip (die) and a semiconductor substrate without a gap, and therefore prevents peeling and adhesion failure. With these properties, there is an advantage of improving the production efficiency of fine, high-precision semiconductor devices such as MEMS devices, as well as improving the performance, the reliability, and yields of the semiconductor devices.

### EXAMPLES

The hot-melt curable silicone composition of the present invention and manufacturing method thereof are described in detail using examples and comparative examples. Note that in the formulas, Me and Vi represent a methyl group and a vinyl group, respectively. Furthermore, the curable silicone compositions of each example and comparative example were measured by methods below for the softening points and for the strengths with which the compositions adhere to the dicing tape. The results are shown in Table 1.

### [Softening Point]

The curable silicone composition was molded into cylindrical pellets of φ14 mm x 22 mm. The pellet was placed on a hot plate set at 25°C to 100°C and continuously pressed from above for 10 seconds by a load of 100 grams, and after the load was removed, the amount of deformation of the pellet was measured. The temperature at which the deformation amount in the height direction was 1 mm or more was defined as the softening point.

### [Peel Strength]

A silicone sheet composed of a curable silicone composition and protected on both sides with peeling liners was prepared, and the liner on one side was peeled off, and the silicone sheet was bonded, at a room temperature, to a UV-curable dicing tape (Adwill series; product number D841) produced by Lintec Corporation. The resultant laminate composed of the peeling liner, the silicone sheet, and the dicing tape was cut into a strip shape of 2 cm × 15 cm. Then, the peeling liner was peeled off from the silicone sheet, and the silicone sheet was bonded to a SUS plate at room temperatures to prepare a laminate composed of the SUS plate, the silicone sheet, and the dicing tape. The SUS plate of the laminate was used as a support, and the peel strength between the silicone sheet and the dicing tape was measured with a Tensilon. The tensile speed was set to 500 mm/min, and the mean value of the peel strength [N] was read. Further, the laminate of the SUS plate, the silicone sheet and the dicing tape was irradiated with ultraviolet light having wavelengths of 365 nm from the dicing tape side so that the irradiation amount became 10 J/cm². Then, the peel strength between the silicone sheet and the dicing tape was measured again. Since no heat is applied at the time of measurement, the silicone sheet is in an uncured state.

### [Examples and Comparative Examples: Preparation of Curable Silicone Sheet Having Hot-Melt Properties]

In each of the examples and comparative examples, the components shown below were weighed in their respective amounts shown in Table 1. Toluene was added in an amount of 25 mass% relative to the total amount of the components, followed by mechanical stirring to dissolve all the components, thereby preparing a solution composed of the curable silicone composition and toluene. The resultant solutions were coated to a thickness of 150 µm on a releasable film (Biwa liner FL2-01 produced by Takara Inc.) and dried for 10 minutes in a hot air circulation oven set to 70°C to prepare a film composed of curable silicone compositions with a thickness of about 100 µm.
▪ Component (A1):
   An organopolysiloxane resin which is a white solid at 25°C and represented by the following average unit formula:

   (Me₂ViSiO_{1/2})_{0.05}(Me₃Si0_{1/2})₀.₃₉(Si0_{4/2})₀.₅₆(HO_{1/2})₀.₀₂

   (wherein the content of vinyl group is 1.9 mass%, and the mass reduction rate when exposed at 200°C for 1 hour is 0.7%)
▪ Component (A2):
   An organopolysiloxane resin which is a white solid at 25°C and represented by the following average unit formula:

   (Me₃SiO_{1/2})_{0.44}(SiO_{4/2})_{0.56}(HO_{1/2})_{0.02}

   (wherein the content of vinyl group is 0 mass%, and the mass reduction rate when exposed at 200°C for 1 hour is 0.7%)
▪ Component (B1):
   Branched dimethylpolysiloxiane capped at both molecular terminals with dimethylvinylsiloxy groups represented by the following formula:

   ViMe₂SiO(Me₂SiO)₈₀₀SiMe₂ViMe₂

   (wherein the content of vinyl group is 0.09 mass%)
▪ Component (B2):
   Branched dimethylpolysiloxiane capped at both molecular terminals with dimethylvinylsiloxy groups represented by the following formula:

   ViMe₂SiO(Me₂SiO)₇₀₀₀SiMe₂ViMe₂

   (wherein the content of vinyl group is 0.01 mass%)
▪ Component (C1-1):
   Branched organohydorogenpolysiloxane represented by the following formula:

   (PhSiO_{3/2})_{0.4}(HMe₂SiO_{1/2})_{0.6}

   (wherein the content of SiH group is 0.6 mass%).
▪ Component (C1-2):
   Linear organohydrogenpolysiloxane represented by the following formula:

   HMe₂SiO(Me₂SiO)₃₇(MeHSiO)₃₇SiMe₂H

   (wherein the content of SiH group is 0.7 mass%)
▪ Component (C1-3):
   Branched organohydrogenpolysiloxane represented by the following formula:

   (HMe₂SiO_{1/2})_{0.52}(Me2SiO_{2/2})_{0.15}(SiO_{4/2})_{0.33}

   (wherein the content of SiH group is 0.79 mass%).
▪ Component (C1-4): (Methylcyclopentadienyl) trimethyl platinum (IV)
▪ Component (C2): bis-(2-methylbenzoyl) peroxide
▪ Component (D): Aerosol silica [manufactured by Nippon Aerosil Co., Ltd., trade name: Aerosil RDX200 (BET-method specific surface area 200 m²/g)]
▪ Component (E) Methyltris-1,1-dimethyl-2-propynyloxysilane

**[Table 1]**

| [Table 1-1] | | | | | | |
|---|---|---|---|---|---|---|
| | EXAMPLE 1 | EXAMPLE 2 | EXAMPLE 3 | EXAMPLE 4 | EXAMPLE 5 | EXAMPLE 6 |
| A1 | 24.0 | 24.0 | 30.9 | 37.6 | 37.6 | 30.9 |
| A2 | 44.6 | 44.6 | 37.7 | 30.8 | 30.8 | 37.7 |
| B1 | 26.0 | | 23.0 | 25.9 | 23.0 | 23.0 |
| B2- | | 26.0 | | | | |
| C1-1 | 3.0 | 3.0 | | 4.5 | | |
| C1-2 | | | | | | |
| C1-3 | | | 3.0 | | 3.6 | |
| C1-4 | 6 ppm | 6 ppm | 8 ppm | 10 ppm | 12 ppm | |
| C2 | | | | | | 2.0 |
| D | 3.8 | 3.8 | 3.8 | 8.1 | 7.8 | 3.8 |
| E | 300 ppm | 300 ppm | 400 ppm | 500 ppm | 600 ppm | |
| (A1 + A2)/B | 2.6 | 2.6 | 3.0 | 2.6 | 3.0 | 3.0 |
| D (mass%) | 3.9 | 3.9 | 4.0 | 8.2 | 8.2 | 4.1 |
| Softening temperature (°C) | 95 | 95 | 105 | 100 | 110 | 110 |
| Peel Strength before UV Radiation (N/20 mm) | > 20 | > 20 | > 20 | 18 | 15 | 19 |
| Peel Strength after UV Irradiation (N/20 mm) | 2.4 | 3.6 | 1.1 | 1.9 | 0.9 | 0.9 |

**[Table 1-2]**

| | COMPARATIVE EXAMPLE 1 | COMPARATIVE EXAMPLE 2 | COMPARATIVE EXAMPLE 3 | COMPARATIVE EXAMPLE 4 | COMPARATIVE EXAMPLE 5 | COMPARATIVE EXAMPLE 6 | COMPARATIVE EXAMPLE 7 | COMPARATIVE EXAMPLE 8 |
|---|---|---|---|---|---|---|---|---|
| A1 | 37.6 | 44.4 | 24.0 | 30.9 | 37.6 | 37.6 | 37.6 | 44.4 |
| A2 | 30.8 | 23.9 | 44.6 | 37.7 | 30.8 | 30.8 | 30.8 | 23.9 |
| B1 | 25.7 | 23.0 | 28.4 | 29.0 | 28.0 | 29.0 | 29.0 | 20.0 |
| B2- | | | | | | | | |
| C1-1 | | 5.3 | 3.0 | | 4.5 | | | 5.3 |
| C1-2 | 5.2 | | | | | | | |
| C1-3 | | | | 2.95 | | 3.6 | 3.6 | |
| C1-4 | 10 ppm | 10 ppm | 6 ppm | 8 ppm | 10 ppm | 12 ppm | 12 ppm | 10 ppm |
| C2 | | | | | | | | |
| D | | | 3.8 | 3.8 | 8.1 | 7.8 | 13 | |
| E | 200 ppm | 500 ppm | 300 ppm | 400 ppm | 500 ppm | 600 ppm | 600 ppm | 500 ppm |
| (A1 + A2)/B | 2.7 | 3.0 | 2.4 | 2.4 | 2.4 | 2.4 | 2.4 | 3.4 |
| D (mass%) | 0.0 | 0.0 | 3.8 | 3.8 | 8.0 | 7.7 | 12.9 | 0.0 |
| Softening temperature °C) | 85 | 95 | 85 | 95 | 90 | 90 | >120 | >120 |
| Peel Strength before UV Radiation (N/20 mm) | >20 | >20 | >20 | >20 | >20 | >20 | 5 | 6 |
| Peel Strength after UV Irradiation (N/20 mm) | >20 | >20 | >20 | >20 | >20 | >20 | 0.3 | 0.4 |

### [Summary]

It was found that the curable silicone compositions of Examples 1 to 6 according to the present invention can be suitably used as the die attach film described above because the mass ratio of (A1 + A2)/B is in a particular range and the amount of the component (D) is in a particular range, and thus the curable silicone compositions exhibit good hot-melt properties and exhibit sufficient peel strength with the dicing tape before UV radiation, but the peel strength is significantly reduced after UV radiation. That is, the curable silicone composition according to the present invention has excellent temporary fixing properties during dicing, and can realize easy peelability of a dicing tape after a dicing step.

On the other hand, it was found that in Comparative Examples 1 and 2 in which the component (D) was not contained, even when the mass ratio of (A1 + A2)/B was in the range of 2.5 to 3.0, the adhesiveness to the dicing tape after UV irradiation was too strong to easily peel off the dicing tape. In addition, it was found that in Comparative Example 8 in which the mass ratio of (A1 + A2)/B was increased to 3.0 or higher, the composition was hardly adhered to the dicing tape at the time before the UV radiation regardless of the presence or absence of the component (D), and the hot-melt property was also worsened.

In addition, even when the content of the component (D) is 2 to 10% by mass as in Comparative Examples 3 to 6, in a case where the mass ratio of (A1 + A2)/B is 2.5 or less, the adhesive strength to the dicing tape is not reduced even after the UV irradiation, and the easy peelability cannot be realized. Furthermore, it was found that when the content of the component (E) is 10% by mass or more as in Comparative Example 7, the composition does not sufficiently adhere to the dicing tape before UV radiation regardless of the value of (A1 + A2)/B, and the hot-melt property is worsened.

## Claims

1. A curable silicone composition comprising: (A) an organopolysiloxane resin containing a component (A1) and a component (A2) below at a mass ratio of 0:100 to 90:10:
(A1) an organopolysiloxane resin having no hot-melt properties as a whole molecule, having a curing reactive functional group containing a carbon-carbon double bond in the molecule, and containing a siloxane unit represented by SiO_{4/2} making up at least 20 mol% or more of the total siloxane units, and
(A2) an organopolysiloxane resin having no hot-melt properties as a whole molecule, having a curing reactive functional group containing at least one carbon-carbon double bond in the molecule, and containing at least 20 mol% or more of the total siloxane units represented by SiO_{4/2};
(B) a straight-chain or branched-chain organopolysiloxane, liquid at 25°C, having a curing reactive functional group containing at least two carbon-carbon double bonds in the molecule;
(C) one or more curing agents selected from (c1) or (c2) below, in an amount necessary to cure the composition:
(c1) an organic peroxide; and
(c2) an organohydrogenpolysiloxane having at least two silicon atom-bonded hydrogen atoms per molecule and a hydrosilylation reaction catalyst; and
(D) aerosol silica
and having hot-melt properties for the composition as a whole, the curable silicone composition **characterized in that**
a mass ratio of the component (A) to the component (B) (=(A)/(B)) is in a range of 2.50 to 3.00, and a content of the component (D) contained in a total amount of the components (A) to (D) is in a range of 2.0 to 10 mass%.

2. The curable silicone composition according to claim 1, wherein the component (A) is an organopolysiloxane resin having a mass reduction ratio of 2.0 mass% or less when exposed to 200°C for one hour.

3. The curable silicone composition according to claim 1, wherein the component (A1) is (A1-1) an non-hot-melt organopolysiloxane resin which is represented by the average unit formula below:
(R¹₃SiO_{1/2})ₐ(R¹₂SiO_{2/2})_{b}(R¹SiO_{3/2})c(SiO_{4/2})_{d}(R²O_{1/2})ₑ
(wherein each R¹ independently represents a monovalent hydrocarbon group with 1 to 10 carbon atoms, but 1 to 12 mol% of all R¹s in a molecule represents an alkenyl group; each R² represents a hydrogen atom or an alkyl group with 1 to 10 carbon atoms; and a, b, c, d, and e represent numbers that satisfy 0.10 ≤ a ≤ 0.60, 0 ≤ b ≤ 0.70, 0 ≤ c ≤ 0.80, 0 ≤ d ≤ 0.65, and 0 ≤ e ≤ 0.05, but c + d > 0.20 and a + b + c + d = 1);
wherein the component (A2) is (A2-1) a non-hot-melt organopolysiloxane which is represented by the average unit formula below:
(R³₃SiO_{1/2})_{f}(R³₂SiO_{2/2})_{g}(R³SiO_{2/2})ₕ(SiO_{4/2})i (R²O_{1/2})ⱼ
(wherein each R³ independently represents a monovalent hydrocarbon group with 1 to 10 carbon atoms and that does not contain a carbon-carbon double bond; R² represents a hydrogen atom with an alkyl group with 1 to 10 carbon atoms; and f, g, h, i, and j represent numbers that satisfy 0.35 ≤ f ≤ 0.55, 0 ≤ g ≤ 0.20, 0 ≤ h ≤ 0.20_{,} 0.45 ≤ i ≤ 0.65, 0 ≤ j ≤ 0.05, and f + g + h + i = 1); and
wherein the component (B) is (B1) a linear diorganopolysiloxane represented by a structural formula below:
R⁴₃SiO(SiR⁴₂O)ₖSiR⁴₃
(wherein, each R⁴ is independently a monovalent hydrocarbon group having 1 to 10 carbon atoms, except that at least two of the R⁴ in one molecule is an alkenyl group, and k is a number from 400 to 10,000).

4. The curable silicone composition according to claim 1, wherein the component (D) is (D1) an aerosol silica having a BET specific surface area of 100 m²/g or more, which is surface-treated with one or more silicon-containing compounds selected from an organoalkoxysilane, an organohalosilane, an organosilazane, and a siloxane oligomer.

5. The curable silicone composition according to claim 1, wherein the component (C) comprises at least
(c1-1) an organohydrogenpolysiloxane having at least two silicon atom-bonded hydrogen atoms per molecule and (c1-2) a hydrosilylation reaction catalyst; and
wherein the organohydrogenpolysiloxane component of (c1-1) above has a content such that a molar ratio of a silicon-bonded hydrogen atom in the organohydrogenpolysiloxane resin relative to the curable reactive functional group containing a carbon-carbon double bond in the components (A) and (B) is in the range of 0.5 to 20.

6. The curable silicone composition according to claim 1, wherein the component (C) is an organic peroxide having a 10-hour (c2) half life achieved at a temperature of 65°C or higher.

7. The curable silicone composition according to claim 1, further comprising: (E) a curing retarding agent for a hydrosilylation reaction with a boiling point of 200°C or higher under atmospheric pressure in an amount of 1 to 5000 ppm, based on the total mass of the composition.

8. The curable silicone composition according to any one of claims 1 to 7, wherein the curable silicone composition is for a die attach film.

9. The curable silicone composition according to any one of claims 1 to 7, wherein the curable silicone composition is in a form of a sheet or a film having a thickness of 10 to 2000 µm.

10. The curable silicone composition according to any one of claims 1 to 7, wherein when the curable silicone composition is used for a die attach film application and is laminated with a dicing tape whose adhesive strength is reduced by irradiation with a high energy beam, an adhesive strength of the curable silicone composition to the dicing tape is reduced from an adhesive strength before the irradiation with a high energy beam to an adhesive strength after the irradiation with the high energy beam by at least 30% or more to make the curable silicone composition easily peelable.

11. A cured product obtained through a curing reaction of the curable silicone composition according to any one of claims 1 to 9 caused by at least one curing stimulus selected from heating and a high energy beam irradiation.

12. The cured product according to claim 11, wherein the cured product is used for the purpose of bonding a semiconductor chip or a semiconductor wafer to an attachment portion therefor.

13. A peelable laminate comprising: (L1) a dicing tape having a property of reducing an adhesive strength caused by irradiation of a high energy beam;
(L2) a layer comprising a curable silicone composition according to any one of claims 1 to 9 closely adhered to one surface of the dicing tape; and
(L3) a sheet-like substrate having a peeling surface facing the layer comprising a curable silicone composition.

14. A peelable laminate comprising: (L1) a dicing tape having a property of reducing an adhesive strength caused by irradiation of a high energy beam;
(L2) a layer comprising a curable silicone composition according to any one of claims 1 to 9 closely adhered to one surface of the dicing tape; and
(W) a semiconductor wafer or a semiconductor chip, at least part of which is closely adhered to the layer comprising the curable silicone composition.

15. A laminate comprising: (L2C) a layer comprising the curable silicone composition according to any one of claims 1 to 9, obtained by peeling, from the surface thereof, the dicing tape irradiated with a high energy beam; and
(W) an individualized chip for semiconductors, at least a part of which is closely adhered to the L2C layer.

16. The laminate according to claim 14 or claim 15, wherein the laminate is a member for a semiconductor or a precursor for a semiconductor.

17. A semiconductor device comprising a structure that comprises: a substrate; and a semiconductor chip or a semiconductor wafer secured to the substrate with a cured product obtained by curing a curable silicone composition according to any one of claims 1 to 9.

18. The semiconductor device according to claim 17, wherein the semiconductor device is a MEMS (micro electro mechanical systems) device.

19. A method of manufacturing a semiconductor device, comprising the steps of:
(1) laminating, onto a back surface of a semiconductor wafer, a sheet or film comprising a curable silicone composition according to any one of claims 1 to 9, with one surface of which sheet or film a dicing tape is in close contact, the dicing tape having a property of reducing an adhesive strength caused by irradiation with a high energy beam;
(2) dicing and thereby individualizing a resultant laminate from the step (1);
(3) irradiating the dicing tape with a high energy beam and thereby reducing the adhesive strength of the dicing tape;
(4) peeling off the dicing tape from the one surface of the curable silicone composition whose adhesive strength to the dicing tape has been reduced in the step (3);
(5) disposing an individual piece of the semiconductor wafer on a semiconductor substrate via the resultant curable silicone composition from the step (4); and
(6) performing a curing reaction that includes heating a resultant structure from the step (5) with the individual piece of the semiconductor wafer disposed on the semiconductor substrate and thereby bonding the individual piece of the semiconductor wafer onto the semiconductor substrate.

20. A method of manufacturing a semiconductor device, comprising the steps of:
(1) individualizing, into a size approximate to a semiconductor chip, a sheet or film comprising a curable silicone composition according to any one of claims 1 to 9, the sheet or film having a dicing tape closely adhered to one surface thereof, the dicing tape having a property of reducing an adhesive strength caused by irradiation with a high energy beam;
(2) disposing a sheet or film composed of a resultant individualized curable silicone composition from the step (1) on a semiconductor substrate;
(3) irradiating the dicing tape with a high energy beam and thereby reducing the adhesive strength of the dicing tape;
(4) peeling off the dicing tape from the one surface of the curable silicone composition whose adhesive strength to the dicing tape has been reduced in the step (3);
(5) disposing an individual piece of the semiconductor wafer on a semiconductor substrate via a resultant curable silicone composition from the step (4); and
(6) performing a curing reaction that includes heating a resultant structure from the step (5) with the individual piece of the semiconductor wafer disposed on the semiconductor substrate and thereby bonding the individual piece of the semiconductor wafer onto the semiconductor substrate.

21. The method for producing a semiconductor device according to claim 19 or claim 20, wherein the step (6) includes a step of pressure-bonding with heating the curable silicone composition having hot-melt properties at a temperature in a range of 50 to 200°C.
